# EUROPEAN PATENT APPLICATION

(11) **EP 4 598 324 A1**
(43) Date of publication of application: **06.08.2025**
(21) Application number: 23929184.2
(22) Date of filing: 28.03.2023
(51) Int. Cl.: H10K 59/82

(54) **DISPLAY PANEL AND PREPARATION METHOD THEREFOR , AND DISPLAY DEVICE**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: QIN, Chaoxue, Beijing 100176 (CN); SUN, Jiamian, Beijing 100176 (CN); LUO, Hui, Beijing 100176 (CN); YANG, Zerong, Beijing 100176 (CN); QIU, Yuheng, Beijing 100176 (CN); KIM, Hwang, Beijing 100176 (CN); LIN, Wei, Beijing 100176 (CN)
(74) Representative: Durán-Corretjer, S.L.P.
(86) International application number: PCT/CN2023/084474
(87) International publication number: WO 2024/197585

(57) **Abstract**

A display panel, comprising: a substrate (10), a display structure layer, a touch-control structure layer (50), a plurality of contact pads (71, 72), and a first inorganic insulating layer (701), wherein the display structure layer is located on the substrate (10) in a display area (AA) and comprises a plurality of display-area metal layers; the touch-control structure layer (50) is located on the side of the display structure layer away from the substrate (10); the plurality of contact pads (71, 72) are located in a first border area (B1), and at least one of the contact pads (71, 72) comprises at least one contact-pad metal layer; the first inorganic insulating layer (701) exposes at least part of the surface, which faces away from the substrate (10), of the contact-pad metal layer of the plurality of contact pads (71, 72); and the contact-pad metal layer, which is exposed by the first inorganic insulating layer (701), of the at least one of the contact pads (71, 72) and one of the plurality of display-area metal layers of the display structure layer are on the same layer.

## Description

### Technical Field

The present disclosure relates to, but is not limited to, the field of display technologies, and particularly to a display panel, and a preparation method therefor, and a display apparatus.

### Background

An Organic light emitting Diode (OLED) is an active display apparatus and has advantages such as self-luminescence, wide view, high contrast, low power consumption, extremely high response speed, etc. With the continuous development of display technology, a display apparatus using an OLED as a light emitting device and a Thin Film Transistor (TFT) for signal control has become a mainstream product in the field of display at present.

### Summary

The following is a summary of subject matters described herein in detail. This summary is not intended to limit the protection scope of claims.

Embodiments of the present disclosure provide a display substrate, a preparation method for the display panel, and a display apparatus.

In one aspect, an embodiment provides a display panel including a base substrate, a display structure layer, a touch structure layer, a plurality of contact pads, and a first inorganic insulating layer. The base substrate includes a display region and a first bezel region located on a side of the display region. The display structure layer is located on the base substrate of the display region and includes a plurality of display region metal layers. The touch structure layer is located on a side of the display structure layer away from the base substrate. The plurality of contact pads are located in the first bezel region, and at least one contact pad includes at least one contact pad metal layer. The first inorganic insulating layer is located in the first bezel region and on a side of the plurality of contact pads away from the base substrate. The first inorganic insulating layer exposes at least part of surfaces of contact pad metal layers of the plurality of contact pads away from the base substrate. The contact pad metal layer of at least one contact pad exposed by the first inorganic insulating layer and one of the display region metal layers of the display structure layer are of a same layer structure.

In some exemplary implementation modes, the contact pad metal layer of the at least one contact pad exposed by the first inorganic insulating layer includes a laminated structure of at least two metal materials.

In some exemplary implementation modes, the contact pad metal layer of the at least one contact pad exposed by the first inorganic insulating layer includes a three-layer laminated structure of titanium aluminum titanium.

In some exemplary implementation modes, the first inorganic insulating layer covers an edge of the contact pad metal layer of the at least one contact pad exposed by the first inorganic insulating layer.

In some exemplary implementation modes, an overlapping length of the first inorganic insulating layer with one side edge of the contact pad metal layer that is exposed is less than or equal to 10 microns.

In some exemplary implementation modes, the first inorganic insulating layer is not overlapped with an edge of the contact pad metal layer of the at least one contact pad exposed by the first inorganic insulating layer.

In some exemplary implementation modes, the display structure layer includes a plurality of sub-pixels, at least one of the plurality of sub-pixels includes a pixel circuit and a light emitting element, the pixel circuit is electrically connected to the light emitting element through a first transfer electrode and a second transfer electrode, the second transfer electrode is located at a side of the first transfer electrode away from the base substrate. The contact pad metal layer of the at least one contact pad exposed by the first inorganic insulating layer and the second transfer electrode are of a same layer structure.

In some exemplary implementation modes, the first bezel region includes: a signal access region, the signal access region includes a first signal access region and a second signal access region, the second signal access region is located at a side of the first signal access region away from the display region. The plurality of contact pads include a plurality of first contact pads located in the first signal access region and a plurality of second contact pads located in the second signal access region. A quantity of contact pad metal layers of at least one first contact pad of the plurality of first contact pads is greater than a quantity of contact pad metal layers of at least one second contact pad of the plurality of second contact pads.

In some exemplary implementation modes, the at least one first contact pad includes a first contact pad metal layer, a second contact pad metal layer, a third contact pad metal layer, and a fourth contact pad metal layer that are sequentially stacked in a direction away from the base substrate.

In some exemplary implementation modes, the pixel circuit includes at least one thin film transistor and at least one capacitor. The first contact pad metal layer of the at least one first contact pad and a first electrode plate or a second electrode plate of the at least one capacitor are of a same layer structure, the second contact pad metal layer and a source electrode and a drain electrode of the at least one thin film transistor are of a same layer structure, the third contact pad metal layer and the first transfer electrode are of a same layer structure, and the fourth contact pad metal layer and the second transfer electrode are of a same layer structure.

In some exemplary implementation modes, the at least one second contact pad includes a fifth contact pad metal layer and a sixth contact pad metal layer that are sequentially stacked in a direction away from the base substrate.

In some exemplary implementation modes, the fifth contact pad metal layer of the at least one second contact pad and the first transfer electrode are of a same layer structure, and the sixth contact pad metal layer and the second transfer electrode are of a same layer structure.

In some exemplary implementation modes, the first bezel region further includes a bending region and a fan-out trace region located at a side of the signal access region close to the display region, the fan-out trace region is located at a side of the bending region close to the display region. The fan-out trace region is at least provided with a plurality of touch leading out lines. The bending region is at least provided with a plurality of touch bending connection lines. The signal access region is at least provided with a plurality of touch transfer lines; a touch bending connection line is electrically connected with a touch leading out line and a touch transfer line, and a touch transfer line and a contact pad metal layer of one of first contact pads connected with the touch transfer line are of an integral structure.

In some exemplary implementation modes, a touch bending connection line and a touch transfer line connected with the touch bending connection line are of an integral structure.

In some exemplary implementation modes, a touch bending connection line and the first transfer electrode connected thereto are of a same layer structure, and a touch transfer line and the second transfer electrode are of a same layer structure.

In some exemplary implementation modes, the display structure layer includes a plurality of sub-pixels, at least one of the plurality of sub-pixels includes a pixel circuit and a light emitting element. The pixel circuit is electrically connected with the light emitting element through a first transfer electrode. The contact pad metal layer of the at least one contact pad exposed by the first inorganic insulating layer and the first transfer electrode are of a same layer structure.

In some exemplary implementation modes, the touch structure layer includes a touch buffer layer, a first touch conductive layer, a touch interlayer insulating layer, and a second touch conductive layer sequentially stacked away from a side of the base substrate. The first inorganic insulating layer and the touch buffer layer are of a same layer structure. The touch interlayer insulating layer is an organic insulating layer.

In some exemplary implementation modes, the display panel further includes a color filter layer located on a side of the touch structure layer away from the base substrate, the color filter layer includes a color film buffer layer, a black matrix, a plurality of filter units, and a color film protection layer sequentially arranged away from a side of the base substrate; wherein, both the color film buffer layer and the color film protection layer are organic insulating layers.

In another aspect, an embodiment provides a display apparatus, including the aforementioned display panel.

In another aspect, an embodiment provides a preparation method for a display panel, including: providing a base substrate, wherein the base substrate includes a display region and a first bezel region located on a side of the display region, forming a display structure layer in the display region and forming a plurality of contact pads in the first bezel region, wherein the display structure layer includes a plurality of display region metal layers, at least one contact pad of the plurality of contact pads includes at least one contact pad metal layer; forming a touch structure layer on a side of the display structure layer away from the base substrate; and forming a first inorganic insulating layer in the first bezel region, wherein the first inorganic insulating layer is located on a side of the plurality of contact pads away from the base substrate and exposes at least part of surfaces of contact pad metal layers of the plurality of contact pads away from the base substrate; the contact pad metal layer of the at least one contact pad exposed by the first inorganic insulating layer and one of the plurality of display region metal layers of the display structure layer are of a same layer structure.

In some exemplary implementation modes, forming the first inorganic insulating layer in the first bezel region includes: after the display structure layer is formed, depositing a first inorganic insulating thin film covering the plurality of contact pads in the first bezel region; and after the touch structure layer is formed, etching the first inorganic insulating thin film to form a first inorganic insulating layer.

In some exemplary implementation modes, the preparation method further includes: forming a color filter layer on a side of the touch structure layer away from the base substrate after forming the touch structure layer and before etching the first inorganic insulating thin film; wherein, the color filter layer includes a color film buffer layer, a black matrix, a plurality of filter units and a color film protection layer sequentially arranged at a side away from the base substrate, wherein both the color film buffer layer and the color film protection layer are organic insulating layers.

In another aspect, an embodiment provides a display panel including a base substrate, a display structure layer, a touch structure layer, a color filter layer, and a plurality of contact pads. The base substrate includes a display region and a first bezel region located on a side of the display region. The display structure layer is located on the base substrate of the display region, the touch structure layer is located on a side of the display structure layer away from the base substrate, and the color filter layer is located on a side of the touch structure layer away from the base substrate. The plurality of contact pads are located in the first bezel region. Orthographic projections of the touch structure layer and the color filter layer on the base substrate are not overlapped with orthographic projections of the plurality of contact pads on the base substrate.

In some exemplary implementation modes, the display panel further includes a first inorganic insulating layer located in the first bezel region, the first inorganic insulating layer is located on a side of the plurality of contact pads away from the base substrate, the first inorganic insulating layer exposes at least part of surfaces of the plurality of contact pads away from the base substrate. The touch structure layer includes a touch buffer layer, a first touch conductive layer, a touch interlayer insulating layer and a second touch conductive layer which are sequentially stacked away from a side of the base substrate. The first inorganic insulating layer and the touch buffer layer are of a same layer structure.

In some exemplary implementation modes, at least one contact pad of the plurality of contact pads includes at least one contact pad metal layer. The first bezel region includes a first signal access region and a second signal access region, wherein the second signal access region is located at a side of the first signal access region away from the display region. The plurality of contact pads include a plurality of first contact pads located in the first signal access region and a plurality of second contact pads located in the second signal access region. A quantity of contact pad metal layers of at least one first contact pad of the plurality of first contact pads is greater than a quantity of contact pad metal layers of at least one second contact pad of the plurality of second contact pads.

Other aspects of the present disclosure may be comprehended after the drawings and the detailed descriptions are read and understood.

### Brief Description of Drawings

Accompanying drawings are used for providing further understanding of technical solutions of the present disclosure, constitute a part of the specification, and are used for explaining the technical solutions of the present disclosure together with embodiments of the present disclosure, but do not constitute limitations on the technical solutions of the present disclosure. Shapes and sizes of one or more components in the drawings do not reflect actual scales, but are only intended to schematically describe contents of the present disclosure.
FIG. 1 is a schematic diagram of a display panel according to at least one embodiment of the present disclosure.
FIG. 2 is a schematic partial cross-sectional view of a display region a display panel of according to at least one embodiment of the present disclosure.
FIG. 3 is a schematic partial plan view of a touch structure layer according to at least one embodiment of the present disclosure.
FIG. 4 is a schematic partial plan view of a first signal access region according to at least one embodiment of the present disclosure.
FIG. 5 is a schematic partial cross-sectional view along a direction P-P' in FIG. 4.
FIG. 6 is a schematic partial plan view of a second signal access region according to at least one embodiment of the present disclosure.
FIG. 7 is a schematic partial cross-sectional view along a direction R-R' in FIG. 6.
FIG. 8 is a schematic partial plan view of traces of a first bezel region according to at least one embodiment of the present disclosure.
FIG. 9 is a schematic partial cross-sectional view along a direction Q-Q' in FIG. 8.
FIG. 10A is a schematic partial cross-sectional view of a first signal access region after a first inorganic insulating thin film is formed according to at least one embodiment of the present disclosure.
FIG. 10B is a schematic partial cross-sectional view of a second signal access region after a first inorganic insulating thin film is formed according to at least one embodiment of the present disclosure.
FIG. 11A is another schematic partial cross-sectional view of a first signal access region according to at least one embodiment of the present disclosure.
FIG. 11B is another schematic partial cross-sectional view of a second signal access region according to at least one embodiment of the present disclosure.
FIG. 12 is another schematic diagram of a display panel according to at least one embodiment of the present disclosure.
FIG. 13 is a schematic partial plan view of traces of a first bezel region in FIG. 12.
FIG. 14 is a schematic partial cross-sectional view along a direction U-U' in FIG. 13.
FIG. 15 is another schematic partial cross-sectional view along a direction U-U' in FIG. 13.
FIG. 16 is another schematic partial cross-sectional view of a display region of a display panel according to at least one embodiment of the present disclosure.
FIG. 17 is a schematic partial cross-sectional view of a signal access region according to at least one embodiment of the present disclosure.
FIG. 18A is another schematic partial cross-sectional view of a first signal access region according to at least one embodiment of the present disclosure.
FIG. 18B is another schematic partial cross-sectional view of a second signal access region according to at least one embodiment of the present disclosure.
FIG. 19A is another schematic partial cross-sectional view of a first signal access region according to at least one embodiment of the present disclosure.
FIG. 19B is another schematic partial cross-sectional view of a second signal access region according to at least one embodiment of the present disclosure.
FIG. 20 is a schematic partial cross-sectional view of a signal access region according to at least one embodiment of the present disclosure.
FIG. 21 is another schematic partial cross-sectional view of a second signal access region according to at least one embodiment of the present disclosure.
FIG. 22 is another schematic partial cross-sectional view of a second signal access region according to at least one embodiment of the present disclosure.
FIG. 23 is another schematic partial cross-sectional view of a display region of a display panel according to at least one embodiment of the present disclosure.
FIG. 24 is a schematic diagram of a display apparatus according to at least one embodiment of the present disclosure.

### Detailed Description

The embodiments of the present disclosure will be described below with reference to the drawings in detail. Implementation modes may be implemented in multiple different forms. Those of ordinary skills in the art may easily understand such a fact that implementations and contents may be transformed into other forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict.

In the drawings, a size of one or more constituent elements, a thickness of a layer, or a region is sometimes exaggerated for clarity. Therefore, one implementation of the present disclosure is not necessarily limited to the size, and a shape and a size of one or more components in the drawings do not reflect an actual scale. In addition, the accompanying drawings schematically illustrate ideal examples, and an implementation of the present disclosure is not limited to shapes, numerical values, or the like shown in the drawings.

Ordinal numerals "first", "second", "third", etc., in the specification are set not to form limits in numbers but only to avoid confusion between composition elements. In the present disclosure, "plurality" represents two or more than two.

In the specification, for convenience, expressions "central", "above", "below", "front", "back", "vertical", "horizontal", "top", "bottom", "inside", "outside", etc., indicating directional or positional relationships are used to illustrate positional relationships between the composition elements, not to indicate or imply that involved devices or elements are required to have specific orientations and be structured and operated with the specific orientations but only to easily and simply describe the present specification, and thus should not be understood as limitations on the present disclosure. The positional relationships between the constituent elements are changed as appropriate according to a direction where the constituent elements are described. Therefore, appropriate replacements based on situations are allowed, which is not limited to the expressions in the specification.

In the specification, unless otherwise specified and defined, terms "mounting", "mutual connection", and "connection" should be understood in a broad sense. For example, it may be a fixed connection, a detachable connection, or an integral connection; it may be a mechanical connection or a connection; it may be a direct connection, an indirect connection through a middleware, or an internal communication inside two elements. Those of ordinary skills in the art may understand meanings of the aforementioned terms in the present disclosure according to situations.

In the specification, "electrical connection" includes connection of composition elements through an element with a certain electrical action. The "element with a certain electrical action" is not particularly limited as long as electrical signals between the connected constituent elements may be transmitted. Examples of the "element with the certain electrical action" not only include an electrode and a wiring, but also include a switching element such as a transistor, a resistor, an inductor, a capacitor, another element with various functions, etc.

In the specification, a transistor refers to an element which at least includes three terminals, i.e., a gate, a drain, and a source. The transistor has a channel region between the drain (drain electrode terminal, drain region, or drain electrode) and the source (source electrode terminal, source region, or source electrode), and a current can flow through the drain, the channel region, and the source. In the specification, the channel region refers to a region through which a current mainly flows.

In the specification, a first electrode may be a drain and a second electrode may be a source, or, a first electrode may be a source and a second electrode may be a drain. In a case that transistors with opposite polarities are used, or in a case that a direction of a current is changed during operation of a circuit, or the like, functions of the "source" and the "drain" are sometimes interchangeable. Therefore, the "source" and the "drain" are interchangeable in the specification. In addition, the gate may also be referred to as a control electrode.

In the specification, "parallel" refers to a state in which an angle formed by two straight lines is above -10° and below 10°, and thus may include a state in which the angle is above -5° and below 5°. In addition, "perpendicular" refers to a state in which an angle formed by two straight lines is above 80° and below 100°, and thus may include a state in which the angle is above 85° and below 95°.

In this specification, a circle, oval, triangle, rectangle, trapezoid, pentagon or hexagon, etc. is not strictly speaking, but may be an approximate circle, oval, triangle, rectangle, trapezoid, pentagon or hexagon, etc. Some small deformations due to tolerances may exist, for example, chamfers, curved edges and deformations thereof may exist.

In the present disclosure, "about" and "substantially" refer to that a boundary is not defined strictly and a case within a range of process and measurement errors is allowed. In the present disclosure, "substantially the same" refers to a case where numerical values differ by less than 10%. "Symmetry" in the present disclosure refers to that a boundary is not defined strictly and a case where approximate symmetry within a range of process and measurement errors is allowed.

In the present disclosure, "A extends along a B direction" means that A may include a main body portion and a secondary portion connected with the main body portion, the main body portion is a line, a line segment, or a strip-shaped body, the main body portion extends along the B direction, and a length of the main body portion extending along the B direction is greater than a length of the secondary portion extending along another direction. "A extends in in the B direction" in the present disclosure means "the main portion of A extends in the B direction". In the present disclosure, A and B are of an integral structure means that A and B are connected with each other and formed integrally.

In some implementations, the display panel may be integrated with a touch structure. The display substrate may include a Liquid Crystal Display (LCD) substrate, or may be an Organic Light Emitting Diode (OLED) display substrate, or may be a Plasma Display apparatus (such as Plasma Display Panel (PDP)) display substrate, or may be an Electrophoretic Display (EPD) display substrate. For example, the display panel may include an OLED display substrate and a touch structure. The touch structure may be disposed on the encapsulation layer of the display substrate to form a structure of Touch on Thin film Encapsulation (Touch on TFE for short). The display structure and touch structure are integrated together, which has advantages of being light and thin, and foldable, and may meet requirements of products such as flexible folding and narrow bezels.

In some examples, the Touch on TFE structure mainly includes Flexible Multi-Layer On Cell (FMLOC for short) structure and Flexible Single-Layer On Cell (FSLOC for short) structure. The FMLOC structure is based on an operating principle of mutual capacitance detection. Generally, a drive (Tx) electrode and a sensing (Rx) electrode are formed by two layers of metal, and an Integrated Circuit (IC, Integrated Circuit) achieves a touch action by detecting mutual capacitance between the drive electrode and the sensing electrode. The FSLOC structure is based on an operating principle of self-capacitance (or voltage) detection. Generally, a touch electrode is formed by a single layer of metal, and an integrated circuit achieves a touch action by detecting the self-capacitance (or voltage) of the touch electrode.

In the research, the inventor noticed that the bending performance of the display panel integrated with the display structure and the touch structure is weak, and crack problem are easy to occur during the reliability test. In order to improve the crack problem, some inorganic film layers in the touch structure can be changed into organic film layers. However, after using organic film layers in the touch structure, in the preparation process of the display panel, the contact pads provided in the bezel region of the display panel are prone to corrosion, which easily leads to problems such as poor brightness and darkness.

The present embodiment provides a display panel, which includes a base substrate, a display structure layer, a touch structure layer, a plurality of contact pads and a first inorganic insulating layer. The base substrate may include a display region and a first bezel region located on a side of the display region. The display structure layer is located on the base substrate of the display region and includes a plurality of display region metal layers. The touch structure layer is located on a side of the display structure layer away from the base substrate. The plurality of contact pads are located in the first bezel region. At least one contact pad of the plurality of contact pads includes at least one contact pad metal layer. The first inorganic insulating layer is located in the first bezel region and on a side of the plurality of contact pads away from the base substrate, the first inorganic insulating layer exposes at least part of surfaces of contact pad metal layers of the plurality of contact pads away from the base substrate. The contact pad metal layer of at least one contact pad exposed by the first inorganic insulating layer and one display region metal layer of the plurality of display region metal layers of the display structure layer are of a same layer structure. In some examples, the contact pad metal layer of the at least one contact pad exposed by the first inorganic insulating layer may be a contact pad metal layer of the contact pad farthest away from the base substrate.

The display panel according to the embodiment can improve the corrosion of the contact pads in the preparation process by arranging a contact pad metal layer of the plurality of contact pads in the first bezel region farthest away from the base substrate and one of the display region metal layers of the display structure layer to be of a same layer structure, thereby improving the yield of the display panel and further facilitating the promotion of the bending resistance of the display panel.

In some exemplary implementation modes, a contact pad metal layer of at least one contact pad exposed by the first inorganic insulating layer may include a laminated structure of at least two metal materials. For example, the contact pad metal layer of the at least one contact pad exposed by the first inorganic insulating layer may include a three-layer laminated structure of titanium aluminum titanium. For example, a contact pad contact pad metal layer of the contact pad exposed by the first inorganic insulating layer and farthest away from the base substrate may be located in a source-drain metal layer of the display panel.

In some exemplary implementation modes, the first inorganic insulating layer may cover an edge of a contact pad metal layer of at least one contact pad exposed by the first inorganic insulating layer. In some examples, an overlapping length of the first inorganic insulating layer with one side edge of the contact pad metal layer exposed may be less than or equal to 10 microns, e.g. may be greater than or equal to 5 microns and less than or equal to 10 microns. In this example, the first inorganic insulating layer is used to perform edge coverage on a contact pad contact pad metal layer, which is exposed by the first inorganic insulating layer and farthest away from the base substrate, of the contact pad, so that the protection for the contact pad can be improved.

In some exemplary implementation modes, the first bezel region may include a signal access region, the signal access region may include a first signal access region and a second signal access region, and the second signal access region may be located at a side of the first signal access region away from the display region. The plurality of contact pads may include a plurality of first contact pads located in the first signal access region and a plurality of second contact pads located in the second signal access region. A quantity of contact pad metal layers of at least one first contact pad of the plurality of first contact pads may be greater than a quantity of contact pad metal layers of at least one second contact pad of the plurality of second contact pads. For example, contact pad metal layers of at least one first contact pad may be four layers, and contact pad metal layers of at least one second contact pad may be two layers; as another example, contact pad metal layers of at least one first contact pad may be three layers, and contact pad metal layers of at least one second contact pad may be two layers or one layer. However, the embodiment is not limited thereto. In this example, the contact pad metal layers of the first contact pad and the second contact pad are respectively designed, which is beneficial to the trace arrangement design of the signal access region. Moreover, by providing a contact pad formed by stacking a plurality of contact pad metal layers, the resistance of the contact pad can be reduced, which is beneficial to improving the signal transmission performance.

Solutions of this embodiment will be described below through multiple examples.

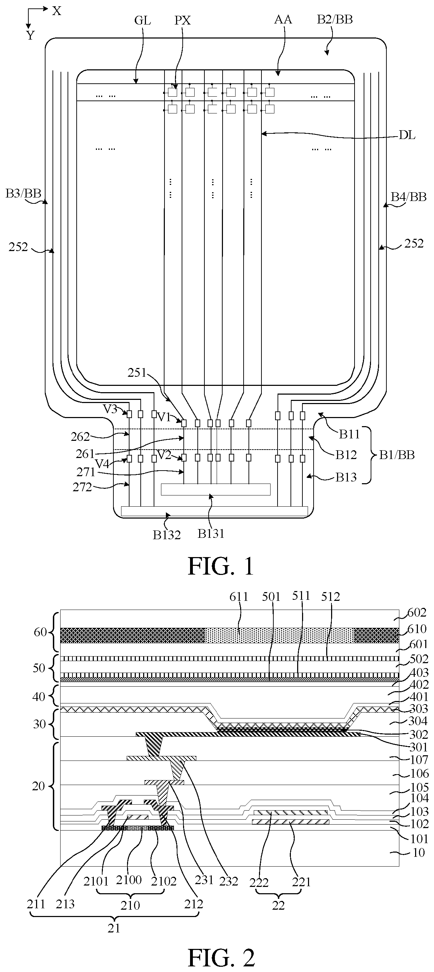

FIG. 1 is a schematic diagram of a display panel according to at least one embodiment of the present disclosure. FIG. 1 is a schematic plan view of the display panel before a bending process. In some examples, as shown in FIG. 1, the display panel may include a display region AA and a peripheral region BB surrounding a periphery of the display region AA. For example, the peripheral region BB may include a first bezel region B1 located on a side of the display region AA, and bezel regions located on other sides of the display region AA (for example, which may include a second bezel region B2, a third bezel region B3, and a fourth bezel region B4). The first bezel region B1 may, for example, be a lower bezel of the display panel, the second bezel region B2 may, for example, be an upper bezel of the display panel, the third bezel region B3 may, for example, be a left bezel of the display panel, and the fourth bezel region B4 may, for example, be a right bezel of the display panel.

In some examples, as shown in FIG. 1, the display region AA may be a planar region including a plurality of sub-pixels PX constituting a pixel array, the plurality of sub-pixels PX may be configured to display a dynamic picture or a static image. The display region AA may be referred to as an Active Area. In some examples, the display region AA may be rectangular. However, the embodiment is not limited thereto. For example, the display region AA may be in other shapes, such as a circle or an ellipse. In some examples, the display panel may be a flexible panel, and accordingly the display panel may be deformable, for example, may be crimped, bent, folded, or curled.

In some examples, as shown in FIG. 1, the display region AA may at least include multiple sub-pixels PX, multiple gate lines GL, and multiple data lines DL. The plurality of gate lines GL may extend in a first direction X and the plurality of data lines DL may extend in a second direction Y. Orthographic projections of the plurality of gate lines GL and the plurality of data lines DL on the base substrate may intersect to form a plurality of sub-pixel regions, and one sub-pixel PX may be disposed in each sub-pixel region. The plurality of data lines DL may be electrically connected with the plurality of sub-pixels PX and the plurality of data lines DL may be configured to provide data signals to the plurality of sub-pixels PX. The multiple gate lines GL may be electrically connected with the multiple sub-pixels PX and the multiple gate lines GL may be configured to provide gate control signals to the multiple sub-pixels PX. In some examples, the gate control signals may include a scan signal and a light emitting control signal, or may include a scan signal, or may include a scan signal, a reset control signal and a light emitting control signal.

In some examples, as shown in FIG. 1, the first direction X may be an extension direction (e.g. a row direction) of the gate lines GL in the display region AA, and the second direction Y may be an extension direction (e.g. a column direction) of the data lines DL in the display region AA. The first direction X and the second direction Y may intersect with each other, for example, they may be perpendicular to each other.

In some examples, a pixel unit of the display region AA may include three sub-pixels which are a red sub-pixel, a green sub-pixel, and a blue sub-pixel respectively. However, the embodiment is not limited thereto. In some examples, one pixel unit may include four sub-pixels, and the four sub-pixels are a red sub-pixel, a green sub-pixel, a blue sub-pixel, and a white sub-pixel respectively. In some examples, a shape of a sub-pixel may be a rectangle, a rhombus, a pentagon, or a hexagon. When one pixel unit includes three sub-pixels, the three sub-pixels may be arranged side by side horizontally, side by side vertically, or in a manner like a Chinese character " 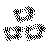 "; when one pixel unit includes four sub-pixels, the four sub-pixels may be arranged side by side horizontally, side by side vertically, or in a shape of a square. However, the embodiment is not limited thereto.

In some examples, one sub-pixel may include a pixel circuit and a light emitting element electrically connected with the pixel circuit. The pixel circuit may include multiple transistors and at least one capacitor. For example, the pixel circuit may be a circuit of a 3T1C, 4T1C, 5T1C, 5T2C, 6T1C, 7T1C, or 8T1C structure. Among them, in the above circuit structure, T refers to a thin film transistor, C refers to a capacitor, a number before T represents a quantity of thin film transistors in the circuit, and a number before C represents a quantity of capacitors in the circuit. In some examples, the plurality of transistors in the pixel circuit may be P-type transistors or may be N-type transistors. Use of a same type of transistors in the pixel circuit may simplify a process flow, reduce a process difficulty of the display substrate, and improve a yield of products. In some other examples, the plurality of transistors in the pixel circuit may include a P-type transistor and an N-type transistor.

In some examples, low temperature poly silicon thin film transistors, or oxide thin film transistors, or low temperature poly silicon thin film transistors and oxide thin film transistors may be used as the plurality of transistors in the pixel circuit. Low Temperature Poly Silicon (LTPS) is used for an active layer of a low temperature poly silicon thin film transistor and an oxide semiconductor (Oxide) is used for an active layer of an oxide thin film transistor. The low temperature poly silicon thin film transistor has advantages such as a high migration rate and fast charging, and the oxide thin film transistor has advantages such as a low leakage current. The low temperature poly silicon thin film transistor and the oxide thin film transistor are integrated on one display substrate, that is, an LTPS + Oxide (LTPO for short) display substrate, advantages of both the low temperature poly silicon thin film transistor and the oxide thin film transistor may be utilized, so that low-frequency drive may be achieved, power consumption may be reduced, and display quality may be improved.

In some examples, the light emitting element may be any of a Light Emitting Diode (LED), an Organic Light Emitting Diode (OLED), a Quantum dot Light Emitting Diode (QLED), a micro LED (including: mini-LED or micro-LED), and the like. For example, the light emitting element may be an OLED, and the light emitting element may emit red light, green light, blue light, or white light, etc. under drive of a pixel circuit corresponding to the light emitting element. A color of light emitted by the light emitting element may be determined as required. In some examples, the light emitting element may include an anode, a cathode, and an organic emitting layer located between the anode and the cathode. The anode of the light emitting element may be electrically connected to a corresponding pixel circuit. However, the embodiment is not limited thereto.

FIG. 2 is a schematic partial cross-sectional view of a display region of a display panel according to at least one embodiment of the present disclosure. FIG. 2 is illustrated by taking a structure of a sub-pixel of the display region as an example. In this example, description is given by taking a case that a plurality of transistors in a pixel circuit are of the same type as an example. For example, a plurality of transistors in a pixel circuit may all be low temperature polysilicon thin film transistors or may all be oxide thin film transistors. In other examples, a plurality of transistors in a pixel circuit may be low temperature polysilicon thin film transistors and oxide thin film transistors. In addition, this example is illustrated by taking a case that the display panel is integrated with a mutual-capacitance touch structure to form an FMLOC structure as an example.

In some examples, as shown in FIG. 2, in a direction perpendicular to the display panel, the display region of the display panel may include a base substrate 10, and a circuit structure layer 20, a light emitting structure layer 30, a encapsulation structure layer 40, a touch structure layer 50, and a color filter layer 60 that are sequentially disposed on the base substrate 10. The display structure layer may include at least a circuit structure layer 20 and a light emitting structure layer 30. The circuit structure layer 20 may include at least pixel circuits of a plurality of sub-pixels, a pixel circuit of each sub-pixel may include a plurality of transistors and at least one capacitor. The light emitting structure layer 30 may include at least light emitting elements of a plurality of sub-pixels.

In some examples, FIG. 2 is illustrated by taking a thin film transistor 21 and a capacitor 22 included in each sub-pixel as an example. In some examples, the circuit structure layer 20 of the display region may include a semiconductor layer, a first gate metal layer, a second gate metal layer, a first source-drain metal layer, a second source-drain metal layer, and a third source-drain metal layer disposed on the base substrate 10. A plurality of display region metal layers of the display structure layer of the present example may include a first gate metal layer, a second gate metal layer, a first source-drain metal layer, a second source-drain metal layer, and a third source-drain metal layer. A first gate insulating layer 101 may be provided between the semiconductor layer and the first gate metal layer, a second gate insulating layer 102 may be provided between the first gate metal layer and the second gate metal layer, an interlayer insulating layer 103 may be provided between the second gate metal layer and the first source-drain metal layer, a passivation layer 104 and a first planarization layer 105 may be provided between the first source-drain metal layer and the second source-drain metal layer, a second planarization layer 106 may be provided between the second source-drain metal layer and the third source-drain metal layer, and a third planarization layer 107 may be provided on a side of the third source-drain metal layer away from the base substrate 10. The first gate insulating layer 101, the second insulating layer 102, the interlayer insulating layer 103 and the passivation layer 104 may be inorganic insulating layers, and the first planarization layer 105, the second planarization layer 106 and the third planarization layer 107 may be organic insulating layers. However, the embodiment is not limited thereto. In other examples, a side of the semiconductor layer close to the base substrate may also be provided with a buffer layer, which may prevent harmful substances in the base substrate from intruding into the interior of the display panel, and may also increase the adhesion of the film layer in the display panel on the base substrate. In other examples, a Bottom Shielding Metal (BSM) layer may be provided on a side of the buffer layer close to the base substrate, and the bottom shielding metal layer may be configured to at least partially cover active layers of thin film transistors of pixel circuits to avoid the influence of external light on the performance of the thin film transistors. In other examples, the passivation layer may be omitted between the first source-drain metal layer and the second source-drain metal layer, and only a first planarization layer may be provided between the first source-drain metal layer and the second source-drain metal layer.

In some examples, as shown in FIG. 2, the semiconductor layer of the display region may include at least an active layer 210 of the thin film transistor 21. The active layer 210 of the thin film transistor 21 may include a first region 2101, a second region 2102, and a channel region 2100 located between the first region 2101 and the second region 2102. The first gate metal layer may include at least a gate 213 of the thin film transistor 21 and a first electrode plate 221 of the capacitor 22. An orthographic projection of the gate 213 of the thin film transistor 21 on the base substrate 10 may cover an orthographic projection of the channel region 2100 of the active layer 210 on the base substrate 10. The second gate metal layer may include at least a second electrode plate 222 of the capacitor 22. Orthographic projections of the second electrode plate 222 and the first electrode plate 221 of the capacitor 22 on the base substrate 10 may be at least partially overlapped, for example, the two may coincide. The first source-drain metal layer may include at least a source 211 and a drain 212 of the thin film transistor 21. The interlayer insulating layer 103 may be provided with a plurality of vias (for example, including a first pixel via and a second pixel via) in the display region, and the interlayer insulating layer 103, the second gate insulating layer 102 and the first gate insulating layer 101 in the first pixel via may be removed to expose at least part of a surface of the first region 2101 of the active layer 210; the interlayer insulating layer 103, the second gate insulating layer 102, and the first gate insulating layer 101 within the second pixel via may be removed to expose at least part of a surface of the second region 2102 of the active layer 210. The source 211 of the thin film transistor 21 may be electrically connected to the first region 2101 of the active layer 210 through the first pixel via, and the drain 212 may be electrically connected to the second region 2102 of the active layer 210 through the second pixel via. The second source-drain metal layer may include at least a first transfer electrode 231. The first transfer electrode 231 may be electrically connected to the drain 212 of the thin film transistor 21 of the pixel circuit through a third pixel via opened in the passivation layer 104 and the first planarization layer 105. The third source-drain metal layer may include at least a second transfer electrode 232. The second transfer electrode 232 may be electrically connected to the first transfer electrode 231 located in the second source-drain metal layer through a fourth pixel via opened in the second planarization layer 106. The second transfer electrode 231 may be electrically connected to the first electrode 301 (e.g. an anode) of the light emitting element through a fifth pixel via opened in the third planarization layer 107. In this example, an electrical connection between the pixel circuit and the light emitting element may be realized through the first transfer electrode 231 and the second transfer electrode 232.

In some examples, a gate line of the display region may be located, for example, in the first gate metal layer, a data line of the display region may be located, for example, in the second source-drain metal layer or the third source-drain metal layer, and a high-potential power supply line of the display region may be located, for example, in at least one of the second source-drain metal layer and the third source-drain metal layer. The embodiment is not limited thereto. The circuit structure layer according to this example can include three source-drain metal layers, which can avoid arranging more traces in a single source-drain metal layer, thereby facilitating the realization of a narrow bezel structure.

In some examples, as shown in FIG. 2, the light emitting structure layer 30 may include a pixel definition layer 304 and a plurality of light emitting elements. For example, each light emitting element may include a first electrode 301, an organic light emitting layer 302 and a second electrode 303 that are stacked. The first electrode 301 of the light emitting element may be an anode, the first electrode 301 may be provided on the third planarization layer 107 and electrically connected to the second transfer electrode 232 through the fifth pixel via opened in the third planarization layer 107. The pixel definition layer 304 is provided on the first electrode 301 and the third planarization layer 107, and may be provided with a plurality of pixel openings, one pixel opening may expose at least part of a surface of a corresponding first electrode 301. At least part of the organic light emitting layer 302 may be disposed within one pixel opening and connected to a corresponding first electrode 301. The second electrode 303 may be disposed on the organic light emitting layer 302 and be connected to the organic light emitting layer 302. The organic light emitting layer 302 may be driven by the first electrode 301 and the second electrode 303 to emit light of a corresponding color. A side of the pixel definition layer 304 away from the base substrate 10 may also be provided with an isolation post layer which may include a plurality of isolation posts (PS).

In some examples, the organic light emitting layer 302 of the light emitting element may include an Emitting Layer (EML for short), and include one or more film layers of a Hole Injection Layer (HIL for short), a Hole Transport Layer (HTL for short), a Hole Block Layer (HBL for short), an Electron Block Layer (EBL for short), an Electron Injection Layer (EIL for short), and an Electron Transport Layer (ETL for short). When driven by voltages of the first electrode 301 and the second electrode 303, light may be emitted according to a required gray scale, in virtue of light emitting characteristics of an organic material.

In some examples, light emitting layers of light emitting elements in different colors may be different. For example, a red light emitting element includes a red light emitting layer, a green light emitting element includes a green light emitting layer, and a blue light emitting element includes a blue light emitting layer. In order to reduce a process difficulty and improve a yield, a hole injection layer and a hole transport layer located on a side of a light emitting layer may be a common layer, and an electron injection layer and an electron transport layer located on another side of the light emitting layer may be a common layer. In some examples, any one or more layers of the hole injection layer, the hole transport layer, the electron injection layer, and the electron transport layer may be made in one process (one evaporation process or one inkjet printing process), and isolation may be achieved by means of a formed film layer surface segment difference or by means of a surface treatment. For example, any one or more of hole injection layers, hole transport layers, electron injection layers, and electron transport layers corresponding to adjacent sub-pixels may be isolated. In some examples, the organic light emitting layer may be manufactured and formed through evaporation using a Fine Metal Mask (FMM for short) or an open mask, or manufactured and formed using an inkjet process.

In some examples, as shown in FIG. 2, the encapsulation structure layer 40 may include a first encapsulation layer 401, a second encapsulation layer 402, and a third encapsulation layer 403 which are stacked. The first encapsulation layer 401 and the third encapsulation layer 403 may be made of an inorganic material, the second encapsulation layer 402 may be made of an organic material, and the second encapsulation layer 402 is disposed between the first encapsulation layer 401 and the third encapsulation layer 403 to ensure that external water vapor cannot enter the light emitting element. However, the embodiment is not limited thereto. For example, an encapsulation structure layer may be of a five-layer stacked structure of inorganic/organic/inorganic/organic/inorganic.

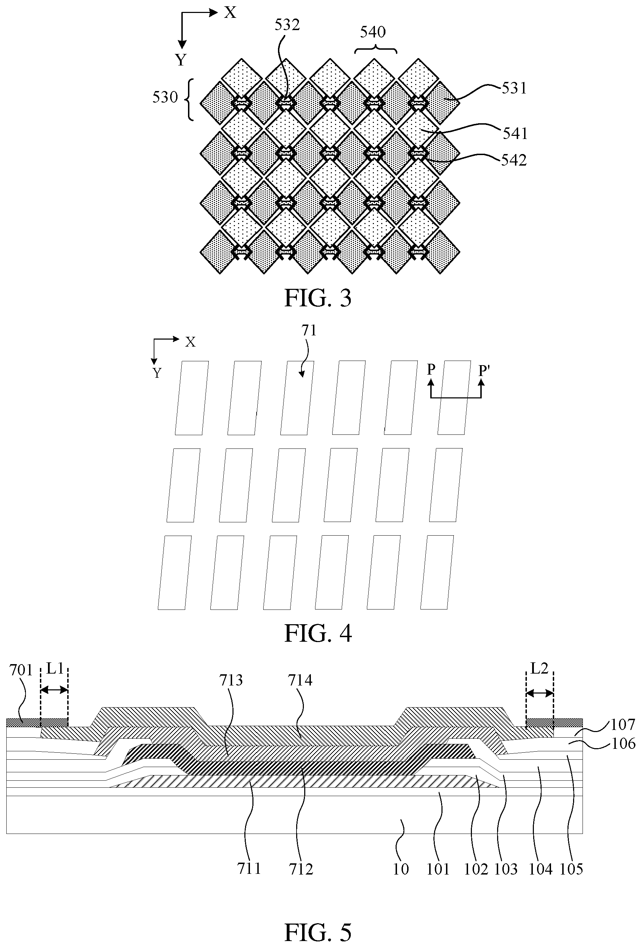

FIG. 3 is a schematic partial plan view of a touch structure layer according to at least one embodiment of the present disclosure. In some examples, as shown in FIG. 3, the touch structure layer in the display region may include a plurality of first touch units 530 and a plurality of second touch units 540. The first touch units 530 may have a shape of a line extending in the first direction X, the plurality of first touch units 530 may be sequentially arranged in the second direction Y, the second touch units 540 may have a shape of a line extending in the second direction Y, and the plurality of second touch units 540 may be sequentially arranged in the first direction X. Each first touch unit 530 may include a plurality of first touch electrodes 531 and first connection parts 532 which are arranged sequentially along the first direction X, and the first touch electrodes 531 and the first connection parts 532 may be disposed alternately and electrically connected sequentially. Each second touch unit 540 may include a plurality of second touch electrodes 541 arranged sequentially along the second direction Y, and the plurality of second touch electrodes 541 are disposed at intervals. Adjacent second touch electrodes 541 may be electrically connected to each other by a second connection part 542. In some examples, a film layer where the second connection parts 542 are located may be different from film layers where the first touch electrodes 531 and the second touch electrodes 541 are located.

In some examples, as shown in FIG. 2, in a direction perpendicular to the display panel, the touch structure layer 50 of the display region may include a touch buffer layer (TBL) 501, a first touch conductive layer 511, a touch interlayer insulating layer (TLD) 502, and a second touch conductive layer 512 arranged sequentially. The touch buffer layer 501 may be an inorganic insulating layer and the touch interlayer insulating layer 502 may be an organic insulating layer. In this example, by providing the touch interlayer insulating layer 502 as an organic insulating layer, the crack problem generated in the reliability test of the display panel (such as the crack problem generated in the reverse arch test of the foldable display panel) can be improved, thereby improving the bending resistance of the display panel, which is beneficial to improving the yield and competitiveness of the display panel.

In some examples, as show in FIG.2 and FIG.3, the multiple first touch electrodes 531, the multiple second touch electrodes 541, and the multiple first connection parts 532 may be disposed on a same layer, i.e., the first touch conductive layer 511, and may be formed through a same patterning process, and the first touch electrodes 531 and the first connection parts 532 may be of an interconnected integra structure. The second connection part 542 may be provided in the second touch conductive layer 512, and may be connected to an adjacent second touch electrode 221 through a via opened in the touch interlayer insulating layer 502. In other examples, the plurality of first touch electrodes 531, the plurality of second touch electrodes 541, and the plurality of second connection parts 542 may be disposed in a same layer, i.e., the first touch conductive layer 511, the second touch electrodes 541 and the second connection parts 542 may be of an interconnected integral structure, the first connection parts 532 may be disposed on the second touch conductive layer 512, and a first connection part 532 and an adjacent first touch electrode 531 may be connected to each other through a via opened in the touch interlayer insulating layer 502. In some examples, the first touch electrodes 531 may be drive (Tx) electrodes and the second touch electrodes 541 may be sensing (Rx) electrodes. Or, the first touch electrodes 531 may be sensing (Rx) electrodes and the second touch electrodes 541 may be drive (Tx) electrodes. This embodiment is not limited thereto.

In some examples, as shown in FIG. 3, the first touch electrodes 531 and the second touch electrodes 541 may be rhombic, for example, they may be in a shape of a square rhombus or a transversally long rhombus or a longitudinally long rhombus. In other examples, the first touch electrodes 531 and the second touch electrodes 541 may have any one or more of shapes of triangles, squares, trapezoids, parallelograms, pentagons, hexagons, and other polygons, which is not limited in embodiments of the present disclosure.

In some examples, as shown in FIG. 3, the first and second touch electrodes 531 and 541 may be in a form of transparent conductive electrodes. In some examples, the first touch electrodes 531 and the second touch electrodes 541 may be in a form of metal meshes. The metal mesh may be formed by a plurality of interweaving metal wires and may include a plurality of mesh patterns. The mesh patterns may be polygons formed by a plurality of metal wires. The first touch electrodes 531 and the second touch electrodes 541 in the form of the metal mesh have advantages of small resistance, small thickness, fast response speed, and the like.

In some examples, as shown in FIG. 2, the color filter layer 60 may be located on a side of the touch structure layer 50 away from the display structure layer. The color filter layer 60 may include a plurality of filter units of different colors (e.g. including filter units 611), black matrixes 610 located between different filter units, a color film buffer layer (CBL) 601 located on a side of the black matrixes 610 and the plurality of filter units close to the base substrate 10, and a color film protection layer (COC) 602 located on a side of the black matrixes 610 and the plurality of filter units away from the base substrate 10. In some examples, the plurality of filter units of the color filter layer 60 may include a plurality of red filter units, a plurality of green filter units and a plurality of blue filter units. The filter units of different colors may correspond to light emitting elements in the light emitting structure layer 30 emitting different colors. For example, a blue filter unit may correspond to a blue light emitting element, an orthographic projection of the blue filter unit on the base substrate may be at least partially overlapped with an orthographic projection of a light emitting region of the blue light emitting element on the base substrate, for example, the orthographic projection of the blue filter unit on the base substrate may cover the orthographic projection of the light emitting region of the blue light emitting element on the base substrate. In the present example, the filter unit can make light of a single color pass through and absorb light of other colors. For example, a blue filter unit can make blue light pass through and absorb light of other colors.

In this example, the color filter layer 60 is formed by adopting the Color On Encapsulation (COE) technology, which can obviously reduce the thickness compared with a polarizer and can achieve a better flexible effect. Moreover, the black matrix 610 and the filter unit of the color filter layer 60 both have a light absorption function compared with the elimination of the natural light by the circular polarizer. When illuminating by external natural light, the natural light will illuminate the sub-pixels thereunder through the filter unit, and the natural light will be reflected by the sub-pixels and then emitted from the filter unit together with the light generated by the sub-pixels themselves, so that the light output rate of the natural light can be improved, thereby realizing the function of reducing power consumption.

In some examples, as shown in FIG. 2, the color film buffer layer 601 and the color film protection layer 602 may both be organic insulating layers. In this example, the color film buffer layer 601 is provided as an organic insulating layer, which can improve the crack problem generated in the reliability test of the display panel (such as the crack problem generated in the reverse arch test of the foldable display panel), improve the bending resistance of the display panel, and is beneficial to improving the yield and competitiveness of the display panel.

In some examples, as shown in FIG. 1, the display structure layers of the third bezel region B3 and the fourth bezel region B4 of the display panel may each include a peripheral circuit region, a power supply line region, a crack dam region, and a cutting region arranged sequentially in a direction away from the display region AA. The peripheral circuit region is connected to the display region AA and may include at least a gate driving circuit (e.g. including a plurality of cascaded shift registers), the plurality of shift registers may be electrically connected to the plurality of gate lines GL in the display region AA and may be configured to supply gate control signals to the plurality of gate lines GL. The power supply line region is connected to the peripheral circuit region and may include at least a low-potential power supply line which may extend in a direction parallel to an edge of the display region and is connected to cathodes of light emitting elements of the display region AA. The crack dam region may be connected to the power supply line region and may at least include multiple cracks disposed on the composite insulating layer. The cutting region may be connected to the crack dam region and may at least include a cutting groove arranged on the composite insulating layer, and the cutting grooves may be configured such that a cutting device can cut along the cutting grooves respectively after preparation of all film layers of the display panel is completed.

In some examples, as shown in FIG. 1, the touch structure layers of the third and fourth bezel regions B3 and B4 of the display panel may each include a plurality of touch leads 252. The plurality of touch leads 252 may be electrically connected to the first touch units and the second touch units respectively. The plurality of touch leads 252 may all be located in the first touch conductive layer or may all be located in the second touch conductive layer; or the plurality of touch leads 252 may be arranged on the first touch conductive layer and the second touch conductive layer alternately. However, the embodiment is not limited thereto.

In some examples, as shown in FIG. 1, the first bezel region B1 of the display panel may include a fan-out trace region B11, a bending region B12, and a signal access region B13 arranged sequentially in a direction away from the display region AA. Only a number of traces within the first bezel region B1 are shown in FIG. 1 for illustrative purposes. The quantity of traces in the first bezel region B1 is not limited in this embodiment.

In some examples, as shown in FIG. 1, the fan-out trace region B11 may be connected to the display region AA. At least a first power supply line, a second power supply line, a plurality of display leading out lines, and a plurality of touch leading out lines 252 may be provided in the fan-out trace region B11. The first power supply line may be configured as a high-potential power supply line connected with the display region AA, and the second power supply line may be configured as a low-potential power supply line connected with the third bezel region B13 and the fourth bezel region B14. The plurality of display leading out lines may include at least a plurality of data leading out lines 251 and a plurality of drive leading out lines (not shown). The plurality of data leading out lines 251 may be electrically connected to the plurality of data lines DL of the display region AA, for example, the plurality of data leading out lines 251 and the plurality of data lines DL may be electrically connected in one-to-one correspondence. The plurality of data leading out lines 251 may extend in the fan-out trace region B11 to the bending region B12 in a fan-out trace manner. The plurality of drive leading out lines may extend from the third and fourth bezel regions B3 and B4 to the fan-out trace region B11, the plurality of drive leading out lines may be electrically connected to the gate drive circuits within the third and fourth bezel regions B3 and B4, and the plurality of drive leading out lines may be configured to provide control signals to the gate drive circuits, for example, the control signals may include a start signal, a clock signal, and the like. The plurality of touch leading out lines 252 may extend from the third and fourth bezel regions B3 and B4 to the fan-out trace region B11 and may be located at a side of the plurality of display leading out lines away from the base substrate.

In some examples, as shown in FIG. 1, the bending region B12 is connected between the fan-out trace region B11 and the signal access region B13, and may be configured such that the signal access region B13 is bent to the back of the display region AA. The bending region B12 may be provided with a plurality of bending connection lines, for example, may include a plurality of data bending connection lines 261, a plurality of drive bending connection lines (not shown), a plurality of touch bending connection lines 262, a first power supply bending connection line (not shown), and a second power supply bending connection line (not shown). The first power supply bending connection line may be electrically connected with the first power supply line, and the second power supply bending connection line may be electrically connected with the second power supply line. The plurality of data bending connection lines 261 may be electrically connected to the plurality of data leading out lines 251, the plurality of drive bending connection lines may be electrically connected to the plurality of drive leading out lines, and the plurality of touch bending connection lines 262 may be electrically connected to the plurality of touch leading out lines 252. For example, in an edge region of the fan-out trace region B11 close to the bending region B12, a data bending connection line 261 may be electrically connected to a data leading out line 251 through a first transfer via V1; a touch bending connection line 262 may be electrically connected to a touch leading out line 252 through a third transfer via V3.

In some examples, as shown in FIG. 1, the plurality of bending connection lines may all extend in the second direction Y. In some examples, the plurality of bending connection lines may be of a same layer structure. In some examples, the plurality of touch bending connection lines 262 may be located at opposite sides of the plurality of data bending connection lines 261 and the plurality of drive bending connection lines in the first direction X. The embodiment is not limited thereto.

In some examples, as shown in FIG. 1, the signal access region B13 may be provided with a plurality of transfer lines, which may include, for example, a plurality of data transfer lines 271 and a plurality of touch transfer lines 272. The plurality of data transfer lines 271 may be electrically connected to the plurality of data bending connection lines 261, for example, in one-to-one correspondence. The plurality of touch transfer lines 272 may be electrically connected to the plurality of touch bending connection lines 262, for example, in one-to-one correspondence. For example, in an edge region of the signal access region B13 close to the bending region B12, a data transfer line 271 may be electrically connected to a data bending connection line 261 through a second transfer via V2, and a touch transfer line 272 may be electrically connected to a touch bending connection line 262 through a fourth transfer via V4.

In some examples, as shown in FIG. 1, the signal access region B13 may include at least one first signal access region B131 and at least one second signal access region B132. This example is illustrated by taking one first signal access region B131 and one second signal access region B132 as an example. In other examples, the display panel may be a large size panel, and the display panel may include a plurality of first signal access regions B131 that may be sequentially arranged along the first direction X and a plurality of second signal access regions B132 that may be sequentially arranged along the first direction X. The first signal access region B131 may be located at a side of the second signal access region B132 close to the display region AA. In other words, the second signal access region B132 may be located at a side of the first signal access region B131 away from the bending region B12 in the second direction Y. In some examples, the signal access region B13 may further include a first circuit region located at a side of the first signal access region B131 close to the bending region B12, and the first circuit region may be provided with a plurality of test circuits (not shown). The test circuit may be configured to be electrically connected to the plurality of data leading out lines 251 through the data transfer lines 271 and the data bending connection lines 261 to supply test data signals to the plurality of data lines DL of the display region AA during a test phase. The first circuit region may also include a plurality of electrostatic discharge circuits to provide a path for electrostatic discharge. In the present example, the data bending connection lines 261 can be electrically connected to the test circuit after being transferred by the data transfer lines 271, and the data transfer lines 271 are located at a side of the data bending connection lines 261 close to the base substrate, thereby facilitating the arrangement of traces connected to the test circuit.

FIG. 4 is a schematic partial plan view of a first signal access region according to at least one embodiment of the present disclosure. In some examples, as shown in FIGS. 1 and 4, the first signal access region B131 may also be referred to as a drive chip provision region. The first signal access region B131 may be provided with a plurality of first contact pads (Bumps) 71, which may be configured to be bonded and connected to at least one drive chip (IC). The drive chip may be configured to generate a drive signal required for driving sub-pixels and to supply the drive signal to the data lines DL of the display region AA. For example, the drive signal may be a data signal that drives the sub-pixels.

In some examples, as shown in FIGS. 1 and 4, the plurality of first contact pads 71 of the first signal access region B131 may be electrically connected to the plurality of display leading out lines in one-to-one correspondence. The plurality of first contact pads 71 of the first signal access region B131 may be arranged in a plurality of rows (e.g. three rows), a plurality of first contact pads 71 included in each row may be arranged sequentially in the first direction X, and the plurality of rows may be arranged sequentially in the second direction Y. However, the embodiment is not limited thereto. In other examples, the first contact pads within the first signal access region B131 may be arranged in a single row.

FIG. 5 is a schematic partial cross-sectional view along a direction P-P' in FIG. 4. FIG. 5 is illustrated by taking a cross-sectional structure of a first contact pad 71 as an example. In some examples, as shown in FIGS. 4 and 5, the first contact pad 71 may include four contact pad metal layers that are stacked, including, for example, a first contact pad metal layer 711, a second contact pad metal layer 712, a third contact pad metal layer 713, and a fourth contact pad metal layer 714. A first inorganic insulating layer 701 may be located on a side of the fourth contact pad metal layer 714 away from the base substrate 10 and may expose a portion of a surface of the fourth contact pad metal layer 714, so that the fourth contact pad metal layer 714 may be electrically connected to pins of the drive chip subsequently. The fourth contact pad metal layer 714 may be located in the third source-drain metal layer and is of a same layer structure with the second transfer electrode of the display region; the third contact pad metal layer 713 may be located in the second source-drain metal layer and is of a same layer structure with the first transfer electrode of the display region; the second contact pad metal layer 712 may be located in the first source-drain metal layer and is of a same layer structure with the source and drain of the thin film transistor in the display region; the first contact pad metal layer 711 may be located in the first gate metal layer. The first contact pad metal layer 711 may be electrically connected to the data transfer line 271, for example, may be of an integral structure with the data transfer line 271. In other examples, the first contact pad metal layer 711 may be located in the second gate metal layer.

In some examples, as shown in FIG. 5, at least a portion of the first inorganic insulating layer 701 may be located in a gap between adjacent first contact pads 71. An edge of the fourth contact pad metal layer 714 of the first contact pad 71 may be covered by the first inorganic insulating layer 701. In this example, the first inorganic insulating layer 701 and the touch buffer layer 501 of the display region may be of a same layer structure. Taking two side edges of the fourth contact pad metal layer 714 in the first direction X as an example, an overlapping length of the first inorganic insulating layer 701 with one side edge of the fourth contact pad metal layer 714 in the first direction X may be a first length L1, and an overlapping length of the first inorganic insulating layer 701 with the other side edge of the fourth contact pad metal layer 714 the first direction X may be a second length L2. For example, the first length L1 and the second length L2 may be substantially the same. For example, the first length L1 and the second length L2 may be greater than 0 and less than or equal to 10 microns, for example, may be greater than or equal to 5 microns and less than or equal to 10 microns. In this example, the first inorganic insulating layer 701 is used to cover an edge of the contact pad metal layer (in this example, the fourth contact pad metal layer 714) of the first contact pad farthest away from the base substrate 10, which can better protect the first contact pad and can improve the situation in which the first contact pad is damaged during the bonding process of the drive chip.

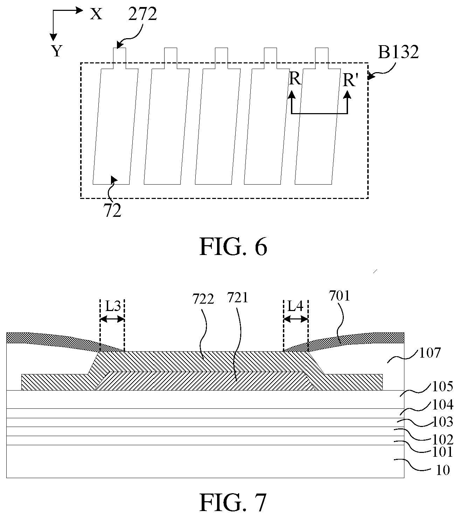

FIG. 6 is a schematic partial plan view of a second signal access region according to at least one embodiment of the present disclosure. In some examples, as shown in FIG. 6, the second signal access region B132 may also be referred to as a circuit bonding region. The second signal access region B132 may be provided with a plurality of second contact pads 72. For example, the plurality of second contact pads 72 may be arranged in a row along the first direction X. The plurality of second contact pads 72 may be configured to be bonded and connected to at least one circuit board (e.g. Flexible Printed Circuit (FPC)). For example, an externally connected circuit board may be configured to generate a touch signal provided to the touch structure and to receive a touch sensing signal. The plurality of second contact pads 72 may be electrically correspondingly connected with the plurality of touch leading out lines and may also be electrically connected with the first power supply line and the second power supply line. In some examples, the plurality of first contact pads may be electrically connected with the plurality of second contact pads through a plurality of pin connection lines for signal transmission between the first signal access region and the second signal access region.

FIG. 7 is a schematic partial cross-sectional view along a direction R-R' in FIG. 6. FIG. 7 is illustrated by taking a cross-sectional structure of a second contact pad 72 as an example. In some examples, as shown in FIGS. 6 and 7, the second contact pad 72 may include two stacked contact pad metal layers which, for example, include a fifth contact pad metal layer 721 and a sixth contact pad metal layer 722. The first inorganic insulating layer 701 may expose a portion of a surface of the sixth contact pad metal layer 722 so that the sixth contact pad metal layer 722 may be bonded and connected to the pins of the circuit board subsequently. For example, an orthographic projection of the sixth contact pad metal layer 722 on the base substrate 10 may cover an orthographic projection of the fifth contact pad metal layer 721 on the base substrate 10, and an edge of the fifth contact pad metal layer 721 in the first direction X may be covered by the sixth contact pad metal layer 722. The laminated design of the contact pad metal layers in this example can be beneficial in ensuring the stability of the laminated structure of the contact pads. In other examples, an edge of the fifth contact pad metal layer 721 in the first direction X may be covered by the second planarization layer 106, and the sixth contact pad metal layer 722 may be in direct contact with a surface of the fifth contact pad metal layer 721 exposed by the second planarization layer. In some examples, the sixth contact pad metal layer 722 may be located in the third source-drain metal layer and be of a same layer structure with the second transfer electrode of the display region; the fifth contact pad metal layer 721 may be located in the second source-drain metal layer and be of a same layer structure with the first transfer electrode of the display region.

In some examples, as shown in FIG. 7, at least a portion of the first inorganic insulating layer 701 may be located in a gap between adjacent second contact pads 72. An edge of the sixth contact pad metal layer 722 of the second contact pad 72 may be covered by the first inorganic insulating layer 701. A surface of the sixth contact pad metal layer 722 exposed by the third planarization layer 107 is in partial contact with the first inorganic insulating layer 701, the first inorganic insulating layer 701 may cover an edge of the sixth contact pad metal layer 722 exposed by the third planarization layer 107. Taking two side edges of the sixth contact pad metal layer 722 in the first direction X as an example, an overlapping length of the first inorganic insulating layer 701 with one side edge of the sixth contact pad metal layer 722 in the first direction X may be a third length L3, and an overlapping length of the first inorganic insulating layer 701 with the other side edge of the sixth contact pad metal layer 722 in the first direction X may be a fourth length L4. The third length L3 and the fourth length L4 may be substantially the same. For example, the third length L3 and the fourth length L4 may be greater than 0 and less than or equal to 10 microns, for example, may be greater than or equal to 5 microns and less than or equal to 10 microns. In some examples, the third length L3 and the first length L1 may be substantially the same. In this example, the first inorganic insulating layer 701 is used to cover an edge of the contact pad metal layer (in this example, the sixth contact pad metal layer 722) of the second contact pad 72 farthest away from the base substrate 10,which can better protect the second contact pad and can improve the situation in which the second contact pad is damaged during the bonding process of the circuit board.

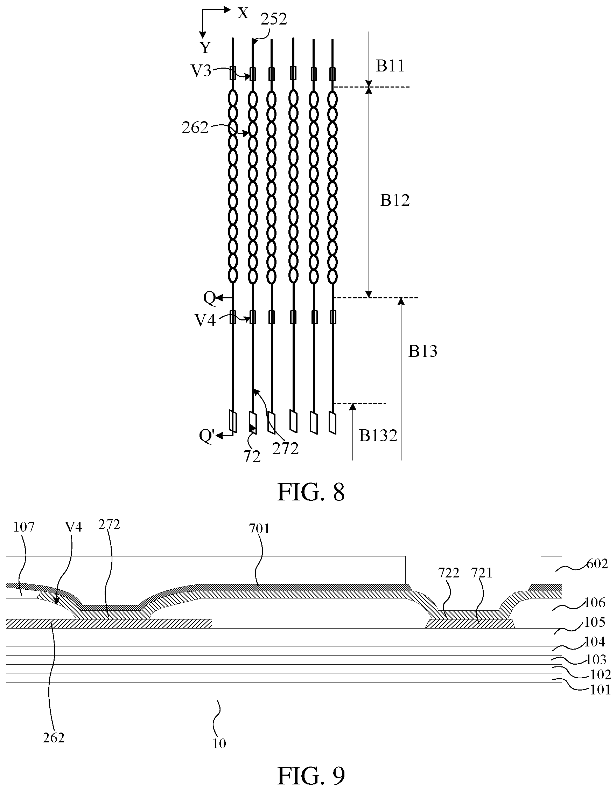

FIG. 8 is a schematic partial plan view of traces of a first bezel region according to at least one embodiment of the present disclosure. FIG. 9 is a schematic partial cross-sectional view along a direction Q-Q' in FIG. 8. In some examples, as shown in FIGS. 8 and 9, the touch leading out lines 252 within the fan-out trace region B11 of the first bezel region may be located in the first touch conductive layer or the second touch conductive layer, and the touch leading out line 252 may be electrically connected to the touch bending connection line 262 located in the second source-drain metal layer through the third transfer via V3 at a position of the fan-out trace region B11 close to the bending region B12. The touch bending connection line 262 of the bending region B12 extends to the signal access region B13, and can be electrically connected to the touch transfer line 272 located in the third source-drain metal layer through the fourth transfer via V4 opened in the second planarization layer 106. The touch transfer line 272 may extend to the second signal access region B132 and be electrically connected to the second contact pad 72 of the second signal access region B132. For example, the sixth contact pad metal layer 722 of the second contact pad 72 and the touch transfer line 272 may be of an integral structure. In this example, the second signal access region B132 may be configured to transmit a touch control signal and a touch sensing signal. However, the embodiment is not limited thereto. In other examples, the first signal access region may be provided with a Touch and Display Driver Integration (TDDI) chip, and the touch transfer line may be electrically connected to the first contact pad of the first signal access region.

In some examples, as shown in FIG. 8, the touch bending connection line 262 of the bending region B12 may have a wavy edge, and the touch bending connection line 262 may further have a plurality of hollowed-out parts, which may be arranged in a column along the second direction Y. Shape of rest of traces in the bending region B12 may be similar to the shape of the touch bending connection line 262, and will not be repeated here. In this example, the edge of the bending connection line in the bending region is set to be wavy and the bending connection line has hollowed-out parts, which can disperse the bending stress to which the bending connection line is subjected during the bending process, can avoid the concentration of stress, reduce the risk of the occurrence of cracks in the bending region, and thus improve the bending effect.

Hereinafter, an exemplary description will be given through a preparation process of a display panel with reference to FIG. 2 to FIG. 9. A "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a base substrate using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process.

"A and B are of a same layer structure" or "A and B are disposed in a same layer" described in the present disclosure means that A and B are formed at the same time through a same patterning process, and a "thickness" of a film layer is a dimension of the film layer in a direction perpendicular to the display panel. In exemplary embodiments of the present disclosure, "an orthographic projection of A includes an orthographic projection of B" or "an orthographic projection of B is located within a range of an orthographic projection of A" means that a boundary of the orthographic projection of B falls within a range of a boundary of the orthographic projection of A, or a boundary of the orthographic projection of A is overlapped with a boundary of the orthographic projection of B.

In an example, a manufacturing process of a display panel may include following operations.
(1) A base substrate is prepared on a glass carrier plate. In some examples, the base substrate 10 may be a flexible substrate, including, for example, a first flexible material layer, a first inorganic material layer, a second flexible material layer, and a second inorganic material layer which are stacked on the glass carrier plate. The first and second flexible material layers may be made of materials such as polyimide (PI), polyethylene terephthalate (PET), or a surface-treated polymer soft thin film. The first inorganic material layer and the second inorganic material layer may be made of Silicon Nitride (SiNx) or Silicon Oxide (SiOx), etc., which are used for improving water and oxygen resistance of the base substrate. The first inorganic material layer and the second inorganic material layer may be also referred to as Barrier layers. However, the embodiment is not limited thereto.
   In some examples, taking a laminated structure of a first flexible material layer/a first barrier layer/a second barrier layer/a second flexible material layer as an example, its preparation process includes: firstly, coating a layer of polyimide on a glass carrier plate, curing it into a film to form a first flexible material layer; then, depositing a layer of barrier thin film on the first flexible material layer to form a first barrier layer covering the first flexible layer; then coating a layer of polyimide is coated on the first barrier layer again, curing it into a film to form a second flexible material layer; and then depositing a layer of barrier thin film on the second flexible material layer to form a second barrier layer covering the second flexible material layer, thereby completing preparation of the flexible base substrate 10.
(2) A semiconductor layer is prepared on the base substrate. In some examples, a semiconductor film is deposited on the substrate 10, and the semiconductor film is patterned by a patterning process to form a semiconductor layer. As shown in FIG. 2, the semiconductor layer may be formed in the display region AA, including at least the active layer 210 of the thin film transistor 21.
(3) A first gate metal layer is prepared on the base substrate. In some examples, a first insulation thin film and a first conductive thin film are sequentially deposited on the base substrate 10 where the aforementioned structure is formed, and the first conductive thin film is patterned through a patterning process to form a first gate insulating layer 101 covering the semiconductor layer, and the first gate metal layer arranged on the first gate insulating layer 101. As shown in FIGS. 1, 2, and 5, the first gate metal layer may include at least the first electrode plate 221 of the capacitor 22, the gate 213 of the thin film transistor 21 and a plurality of gate lines (not shown) located in the display region AA, some of the data leading out lines 251 and some of the drive leading out lines (not shown) located in the fan-out trace region B11 of the first bezel region B1, some of the data transfer lines 271 and some of the drive control transfer lines (not shown) located in the signal access region B13, and a first contact pad metal layer 711 of at least one first contact pad 71 located in the first signal access region B131. For example, the data transfer line 271 and the first contact pad metal layer 711 of the first contact pad 71 connected thereto located in the first gate metal layer may be of an integral structure. The data transfer line 271 in the signal access region B13 may be electrically connected with the test circuit.
(4) A second gate metal layer is prepared on the base substrate. In some examples, a second insulating thin film and a second conductive thin film are sequentially deposited on the base substrate 10 on which the above-mentioned structures are formed, and the second conductive thin film is patterned by a patterning process to form a second gate insulating layer 102 and a second gate metal layer. As shown in FIGS. 1 and 2, the second gate metal layer may include at least a second electrode plate 222 of the capacitor 22 located in the display region AA, some of the data leading out lines 251 and some of the drive leading out lines located in the fan-out trace region B11, some of the data transfer lines 271 and some of the drive transfer lines located in the signal access region B13, and a first contact pad metal layer 711 of at least one first contact pad 71 located in the first signal access region B131. For example, the data transfer line 271 and the first contact pad metal layer 711 of the first contact pad 71 connected thereto located in the second gate metal layer may be of an integral structure. The data transfer line 271 in the signal access region B13 may be electrically connected with the test circuit. In this example, the data transfer line 271 of the signal access region B13 is arranged in the first gate metal layer or the second gate metal layer, which facilitates the access of the data transfer line 271 to the test circuit without the need for a replacement of the film layer for transfer and can simplify the trace design.
   In some examples, the plurality of data leading out lines 251 of the fan-out trace region B11 may be arranged in an overlapping manner in the first gate metal layer and the second gate metal layer, which may reduce crosstalk between adjacent data leading out lines 251, improve signal transmission performance, and reduce the spacing between adjacent data leading out lines, facilitating the realization of a narrow bezel. Likewise, the plurality of drive leading out lines of the fan-out trace region B11 may be configured to be arranged alternately in the first gate metal layer and the second gate metal layer; the plurality of data transfer lines of the signal access region B13 may be configured to be arranged alternately in the first gate metal layer and the second gate metal layer; the plurality of drive transfer lines of the signal access region B13 may be configured to be arranged alternately in the first gate metal layer and the second gate metal layer. However, the embodiment is not limited thereto. In other examples, the plurality of data leading out lines may be disposed in a same layer and the plurality of drive leading out lines may be disposed in a same layer, in the fan-out trace region; or, the plurality of data transfer lines can be disposed in a same layer and the plurality of drive transfer lines can be disposed in a same layer, in the signal access region.
(5) An interlayer insulating layer is prepared on the base substrate. In some examples, a third insulating thin film is deposited on the base substrate 10 on which the above-mentioned structures are formed and the third insulating thin film is patterned by a patterning process to form an interlayer insulating layer 103. As shown in FIG. 2, at least two pixel vias (for example, including a first pixel via and a second pixel via) may be provided on the interlayer insulating layer 103 of the display region AA, and the interlayer insulating layer 103, the second gate insulating layer 102 and the first gate insulating layer 101 within the first pixel via and the second pixel via may be etched away to expose at least part of surfaces of the first region 2101 and the second region 2102 of the active layer 210, respectively. The interlayer insulating layer 103 of the first signal access region B131 may be provided with a plurality of contact vias, for example including a first contact via exposing at least part of a surface of the first contact pad metal layer 711 of the first contact pad 71. For example, the interlayer insulating layer 103 and the second gate insulating layer 102 in the first contact via may be removed to expose a portion of a surface of the first contact pad metal layer 711 located in the first gate metal layer, or the interlayer insulating layer 103 in the first contact via may be removed to expose a portion of a surface of the first contact pad metal layer 711 located in the second gate metal layer.
(6) A first source-drain metal layer is prepared on the base substrate. In some examples, a third conductive thin film is deposited on the base substrate 10 on which the above-mentioned structures are formed and the third conductive thin film is patterned by a patterning process to form a first source-drain metal layer. As shown in FIGS. 2, 5 and 7, the first source-drain metal layer may include at least the source 211 and the drain 212 of the thin film transistor 21 located in the display region AA, and the second contact pad metal layer 712 of the first contact pad 71 located in the first signal access region B131. The source 211 of the thin film transistor 21 may be electrically connected to the first region 2101 of the active layer 210 through the first pixel via, and the drain 212 may be electrically connected to the second region 2101 of the active layer 210 through the second pixel via. The second contact pad metal layer 712 of the first contact pad 71 may be electrically connected to the first contact pad metal layer 711 through the first contact via opened in the interlayer insulating layer 103. A portion of the second contact pad metal layer 712 may extend to a surface of the interlayer insulating layer 103 away from the base substrate 10.
(7) A second source-drain metal layer is prepared on the base substrate. In some examples, a fourth insulating thin film is deposited on the base substrate on which the above-mentioned structures are formed, and then a fifth insulating thin film is coated, and the fifth and fourth insulating thin films are patterned by a patterning process to form a passivation layer 104 and a first planarization layer 105. Subsequently, a fourth conductive thin film is deposited on the base substrate on which the above-mentioned structures are formed, and the fourth conductive thin film is patterned by a patterning process to form a second source-drain metal layer. As shown in FIG. 2, FIG. 5, FIG. 7 to FIG. 9, the second source-drain metal layer may at least include the first transfer electrode 231 located in the display region AA, the plurality of bending connection lines (e.g. including the plurality of data bending connection lines 261 and the plurality of touch bending connection lines 262) located in the bending region B12, the third contact pad metal layer 713 of the first contact pad 71 located in the first signal access region B131, and the fifth contact pad metal layer 721 of the second contact pad 72 located in the second signal access region B132. The first transfer electrode 231 of the display region AA may be electrically connected to the drain 212 of the thin film transistor 21 of the pixel circuit through the third pixel via opened in the first planarization layer 105 and the passivation layer 104.

In some examples, as shown in FIG. 5, in the first signal access region B131, the passivation layer 104 may cover the edge of the second contact pad metal layer 712, and orthographic projections of the first planarization layer 105 and the second contact pad metal layer 712 on the base substrate may not be overlapped. However, the embodiment is not limited thereto. For example, the edge of the second contact pad metal layer 712 may be covered by the first planarization layer 105 or may be covered by the passivation layer 104 and the first planarization layer 105. In this example, the insulating layer is used to cover the edge of the contact pad metal layer, which can improve the corrosion resistance of the contact pad and contribute to improving the yield of the display panel.

In some examples, as shown in FIG. 5, the third contact pad metal layer 713 of the first contact pad 71 may be electrically connected to the second contact pad metal layer 712 through the second contact via opened in the first planarization layer 105 and the passivation layer 104. A portion of the third contact pad metal layer 713 may extend to surfaces of the passivation layer 104 and the first planarization layer 105 away from the base substrate 10. For example, an orthographic projection of the third contact pad metal layer 713 on the base substrate 10 may cover an orthographic projection of the second contact pad metal layer 712 on the base substrate 10.

In this example, the plurality of bending connection lines of the bending region B12 are all located in the second source-drain metal layer, and are electrically connected with corresponding traces in the fan-out trace region and the signal access region through transfer vias. In this example, all traces in the bending region are arranged in the second source-drain metal layer, which is beneficial to reduce the deformation of the traces in the bending region, thus ensuring the signal transmission performance of the traces in the bending region.

In some examples, the bending region B12 may include a first gate insulating layer 101, a second gate insulating layer 102, an interlayer insulating layer 103, a passivation layer 104, and a first planarization layer 105 stacked on the base substrate 10 before the second source-drain metal layer is formed. A first groove and a second groove can be formed in the bending region B12 by two etching processes. For example, the first planarization layer 105 and the passivation layer 104 of the bending region B12 are etched by a first mask (EBA MASK, Etch Bending A MASK) to form the first groove to expose a surface of the interlayer insulating layer 103; the interlayer insulating layer 103, the second gate insulating layer 102, and the first gate insulating layer 101 in the first groove in the bending region B12 are etched by a second mask (EBB MASK, Etch Bending B MASK) to expose a surface of the base substrate 10. As another example, after the passivation layer 104 is formed, the passivation layer 104 in the bending region B12 can be etched by a first mask, then the interlayer insulating layer 103, the second gate insulating layer 102 and the first gate insulating layer 101 in the bending region B12 can be etched by a second mask; and then the first planarization layer 105 is filled in the groove formed in the bending region B12, a plurality of bending connection lines of the bending region B12 may be located on the first planarization layer 105. However, the embodiment is not limited thereto. In this example, the bending region B12 is grooved by EBA MASK and EBB MASK, which can reduce the thickness of the inorganic insulating layer in the bending region B12 and improve the bending effect.

(8) A third source-drain metal layer is prepared on the base substrate. In some examples, a sixth insulating thin film is coated on the base substrate on which the above-mentioned structures are formed and the sixth insulating thin film is patterned by a patterning process to form a second planarization layer 106. Subsequently, a fifth conductive thin film is deposited on the base substrate on which the above-mentioned structures are formed, and the fifth conductive thin film is patterned by a patterning process to form a third source-drain metal layer. Subsequently, a seventh insulating thin film is coated and patterned by a patterning process to form a third planarization layer 107.

In some examples, as shown in FIGS. 2, 5, 7 and 9, the third source-drain metal layer may include at least a second transfer electrode 232 located in the display region AA, a fourth contact pad metal layer 714 of the first contact pad 71 located in the first signal access region B131, a sixth contact pad metal layer 722 of the second contact pad 72 located in the second signal access region B132, and a touch transfer line 272 located in the signal access region B13. The second transfer electrode 232 of the display region AA may be electrically connected to the first transfer electrode 231 through the fourth pixel via opened in the second planarization layer 106.

In some examples, as shown in FIG. 5, the second planarization layer 106 may cover the edge of the third contact pad metal layer 713 in the first signal access region B131. The fourth contact pad metal layer 714 may be electrically connected to the third contact pad metal layer 713 located in the second source-drain metal layer through a third contact via opened in the second planarization layer 106. A portion of the fourth contact pad metal layer 714 may extend to a surface of the second planarization layer 106 away from the base substrate 10. For example, an orthographic projection of the fourth contact pad metal layer 714 on the base substrate 10 may cover an orthographic projection of the third contact pad metal layer 713 on the base substrate 10.

In some examples, as shown in FIGS. 7 and 9, the touch bending connection line 262 may extend into the signal access region B13 and be electrically connected to the touch transfer line 272 located in the third source-drain metal layer through the fourth transfer via V4 opened in the second planarization layer 106. The touch transfer line 272 may extend to the second signal access region B132 and be electrically connected to the second contact pad 72 within the second signal access region B132. The touch transfer line 272 and the sixth contact pad metal layer 722 of the second contact pad 72 connected thereto may be of an integral structure.

Hereto, the circuit structure layer of the display region AA, the first contact pad 71 of the first signal access region and the second contact pad 72 of the second signal access region are prepared on the base substrate. In this example, the first contact pad 71 includes four contact pad metal layers, and the second contact pad 72 includes two contact pad metal layers. Forming a contact pad by providing a plurality of contact pad metal layers is beneficial to reducing the contact pad resistance and improving the signal transmission performance of the contact pad.

In some examples, the first gate insulating layer 101, the second gate insulating layer 102, the interlayer insulating layer 103, and the passivation layer 104 may be inorganic insulating layers, for example, may be made of any one or more of silicon oxide (SiOx), silicon nitride (SiNx), and silicon oxynitride (SiON), and may be in a single layer, multiple layers, or a composite layer. The first planarization layer 105, the second planarization layer 106, and the third planarization layer 107 may be organic insulating layers, for example, may be made of an organic material, such as polyimide, acrylic, or polyethylene terephthalate. The first gate metal layer and the second gate metal layer may be made of a metal material, such as any one or more of silver (Ag), copper (Cu), aluminum (Al), titanium (Ti), and molybdenum (Mo), and may be of a single-layered structure. For example, the first gate metal layer and the second gate metal layer may each include a Mo metal layer. The first source-drain metal layer, the second source-drain metal layer, and the third source-drain metal layer may be made of metal materials, such as any one or more of silver (Ag), copper (Cu), aluminum (Al), titanium (Ti) and molybdenum (Mo), or alloy materials of the aforementioned metals, such as aluminum neodymium alloy (AlNd) or molybdenum niobium alloy (MoNb), and may be of a single-layered structure or a multi-layered composite structure, such as Ti/Al/Ti, etc. For example, the first source-drain metal layer, the second source-drain metal layer, and the third source-drain metal layer may employ a three-layer laminated structure of Ti/Al/Ti. The semiconductor layer may be made of one or more materials, such as amorphous Indium Gallium Zinc Oxide (a-IGZO), Zinc Oxynitride (ZnON), Indium Zinc Tin Oxide (IZTO), amorphous Silicon (a-Si), polycrystalline Silicon (p-Si), hexathiophene, and polythiophene. That is, the present disclosure is applicable to a transistor manufactured based on an oxide technology, a silicon technology, and an organic matter technology. This embodiment is not limited thereto.

(9) A light emitting structure layer is prepared on the base substrate. In some examples, a transparent conductive thin film is deposited on the base substrate 10 on which the above-mentioned structures are formed and the transparent conductive thin film is patterned by a patterning process to form a pattern of a first electrode 301 of the light emitting element. A pixel definition thin film is coated on the base substrate 10 on which the aforementioned structures are formed, and a pattern of a pixel definition layer (PDL) 304 is formed through masking, exposure, and development processes. As shown in FIG. 2, a pixel opening is provided on the pixel definition layer 304 of the display region AA, and a pixel definition thin film in the pixel opening is developed away to expose at least part of a surface of the first electrode 301. For example, the pixel definition layer 304 may be made of an organic material, such as polyimide, acrylic, or polyethylene terephthalate.

Subsequently, the organic emitting layer 302 and the second electrode 303 are sequentially formed on the base substrate 10 on which the aforementioned patterns are formed. As shown in FIG. 2, the organic emitting layer 302 may include a hole injection layer, a hole transmission layer, an emitting layer, an electron transmission layer, and an electron injection layer which are stacked, and is formed in a pixel opening of the display region AA to achieve a connection between the organic emitting layer 302 and the first electrode 301. Since the first electrode 301 is connected to the drain 212 of the thin film transistor 21, light emitting control for the organic light emitting layer 302 is realized. A portion of the second electrode 303 may be formed on the organic emitting layer 302. After the light emitting structure layer 30 is formed in the display region AA, there is no change in the film layer structures of the first contact pad 71 of the first signal access region and the second contact pad 72 of the second signal access region.

(10) An encapsulation structure layer is prepared. In some examples, an encapsulation structure layer 40 is formed on the base substrate 10 on which the abovementioned patterns are formed. As shown in FIG. 2, the encapsulation structure layer 40 may be formed in the display region AA and may adopt a stacked structure of an inorganic material/an organic material/an inorganic material. An organic material layer may be disposed between two inorganic material layers. After the encapsulation structure layer 40 is formed, there is no change in the film layer structures of the first contact pad 71 of the first signal access region and the second contact pad 72 of the second signal access region.

(11) A touch structure layer is prepared. In some examples, a first inorganic insulating thin film 701' is deposited on the base substrate 10 on which the above-mentioned structures. In some examples, the first inorganic insulating thin film 701' may be made of an inorganic insulating material, such as any one or more of silicon oxide (SiOx), silicon nitride (SiNx), and silicon oxynitride (SiON), and may be in a single layer, multiple layers, or a composite layer. In some examples, the thickness of the first inorganic insulating thin film 701' may be 1500 angstroms to 3000 angstroms, such as about 2000 angstroms. The first inorganic insulating thin film 701' may form the touch buffer layer 501 in the display region and form the first inorganic insulating layer 701 in the first bezel region. The touch buffer layer and the first inorganic insulating layer in this example are of a same layer structure. However, the embodiment is not limited thereto. In other examples, the first inorganic insulating layer may be located on a side of the touch buffer layer close to the base substrate, or may be located on a side of the touch buffer layer away from the base substrate.

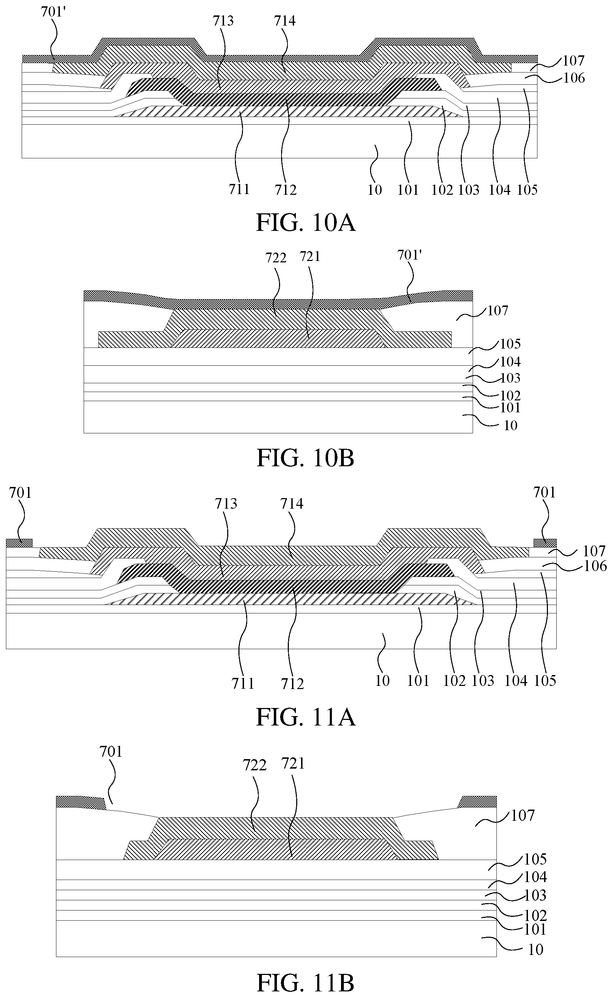

FIG. 10A is a schematic partial cross-sectional view of a first signal access region after a first inorganic insulating thin film is formed according to at least one embodiment of the present disclosure. FIG. 10B is a schematic partial cross-sectional view of a second signal access region after a first inorganic insulating thin film is formed according to at least one embodiment of the present disclosure. In some examples, as shown in FIGS. 10A and 10B, the first inorganic insulating thin film 701' may cover the fourth contact pad metal layer 714 of the first contact pad 71 of the first signal access region, and may also cover the sixth contact pad metal layer 722 of the second contact pad 72 of the second signal access region. In this example, by covering surfaces of the first contact pad 71 and the second contact pad 72 away from the base substrate with the first inorganic insulating thin film 701' during the preparation process, protection of the first contact pad 71 and the second contact pad 72 can be achieved during a subsequent preparation process, and the corrosion of the contact pads in the subsequent preparation process can be improved.

Subsequently, a first touch conductive thin film is deposited, and the first touch conductive thin film is patterned by a patterning process to form a first touch conductive layer 511 on the touch buffer layer 501. For example, the first touch conductive layer 511 may include at least a first touch electrode, a second touch electrode and a first connection part located in the display region AA.

Subsequently, a touch interlayer insulating thin film is coated, and the touch interlayer insulating thin film is patterned by a patterning process to form a touch interlayer insulating layer 502 covering the first touch conductive layer. In some examples, the touch interlayer insulating layer 502 may be an organic insulating layer, for example, may be made of an organic material, such as polyimide, acrylic, or polyethylene terephthalate.

Subsequently, a second touch conductive thin film is deposited, and the second touch conductive thin film is patterned by a patterning process to form a second touch conductive layer 512 on the touch interlayer insulating layer 502. For example, the second touch conductive layer 512 may include at least a second connection part located in the display region AA. In some examples, the touch electrode and the connection part may be in a form of a metal mesh. In some examples, the first and second touch conductive layers 511 and 512 may be made of a metal material, such as any one or more of silver (Ag), copper (Cu), aluminum (Al), titanium (Ti), and molybdenum (Mo), may be of a single-layer structure, or may be of a laminated structure.

In some examples, the first touch conductive layer, the second touch conductive layer, and the touch interlayer insulating layer of the first signal access region B131 and the second signal access region B132 may be removed. For example, after the touch structure layer is prepared, the first signal access region B131 may include a first contact pad 71 disposed on the base substrate 10 and the first inorganic insulating thin film 701' covering the first contact pad 71, and the second signal access region B132 may include the second contact pad 72 disposed on the base substrate 10 and the first inorganic insulating thin film 701' covering the second contact pad 72.

(12) A color filter layer is prepared. In some examples, a color film buffer film is coated on the base substrate 10 on which the above-mentioned structures are formed and the color film buffer film is patterned by a patterning process to form a color film buffer layer 601. The color film buffer layer 601 of the first signal access region and the second signal access region can be removed to avoid influence on subsequent processes. In some examples, the color film buffer layer 601 may be an organic insulating layer, for example, may be made of an organic material, such as polyimide, acrylic, or polyethylene terephthalate.

Subsequently a black pigment is coated or a black chromium (Cr) thin film is deposited and the black pigment or the black chromium thin film is patterned by a patterning process to form a pattern of a black matrix 610 in the display region AA. Subsequently, a plurality of filter units 611 of different colors are sequentially formed in the display region AA. For example, the plurality of filter units may include a plurality of red filter units, a plurality of blue filter units and a plurality of green filter units. Taking the formation of the red filter unit as an example, the structure formed with the black matrix may be coated with a red resin at first, and after baking-curing, the red filter units are formed by masking, exposure and development. The green filter units and the blue filter units are formed through similar processes, which will not be repeated herein. The first signal access region B131 and the second signal access region B132 are not provided with a color film buffer layer 601, a black matrix 610 and a filter unit of the color filter layer; in other words, orthographic projections of the color film buffer layer 601, the black matrix 610 and the filter unit on the base substrate may not be overlapped with the first signal access region B131 and the second signal access region B132.

Subsequently a protective film is coated and patterned by a patterning process to form a color film protection layer 602. The color film protection layer 602 of the first signal access region and the second signal access region may be removed to expose a surface of the first inorganic insulating thin film 701'. In some examples, the color film protection layer 602 may be an organic insulating layer, for example, may be made of an organic material, such as polyimide (PI).

(13) The first inorganic insulating thin film is etched. In some examples, the first inorganic insulating thin film 701' exposed by the color film protection layer 602 is patterned by a patterning process to form the first inorganic insulating layer 701 of the first bezel region. Portions of the first inorganic insulating thin film 701' of the first signal access region B131 and the second signal access region B132 may be etched away so as to expose at least part of a surface of the fourth contact pad metal layer 714 of the first contact pad 71 of the first signal access region B131 and at least part of a surface of the sixth contact pad metal layer 722 of the second contact pad 72 of the second signal access region B132.

In some examples, as shown in FIG. 5, the first inorganic insulating layer 701 may be located in a gap between the fourth contact pad metal layers 714 of adjacent first contact pads 71. The first inorganic insulating layer 701 may be in direct contact with a surface of the fourth contact pad metal layer 714 of the first contact pad 71 away from the base substrate 10, and an edge of the fourth contact pad metal layer 714 of the first contact pad 71 may be covered by the first inorganic insulating layer 701. An overlapping length of one side edge of the fourth contact pad metal layer 714 of the first contact pad 71 with the first inorganic insulating layer 701 may be greater than 0 and less than or equal to 10 microns, for example, may be greater than or equal to 5 microns and less than or equal to 10 microns. In this example, the first inorganic insulating layer 701 is used to perform edge coverage on the first contact pad 71, so that the first contact pad 71 can be effectively protected.

In some examples, as shown in FIG. 7, the first inorganic insulating layer 701 may be located in a gap between the sixth contact pad metal layers 722 of adjacent second contact pads 72. The first inorganic insulating layer 701 may be in direct contact with a surface of the sixth contact pad metal layer 722 of the second contact pad 72 away from the base substrate 10, and a portion of an edge of the sixth contact pad metal layer 722 of the second contact pad 72 may be covered by the first inorganic insulating layer 701. An overlapping length of one side edge of the sixth contact pad metal layer 722 of the second contact pad 72 with the first inorganic insulating layer 701 may be greater than 0 and less than or equal to 10 microns, for example, may be greater than or equal to 5 microns and less than or equal to 10 microns. In this example, the first inorganic insulating layer 701 is used to perform edge coverage on the second contact pad 72, so that the second contact pad 72 can be effectively protected.

In this example, the touch insulating layer 502 of the touch structure layer and the color film buffer layer 601 of the color filter layer can both be prepared using organic materials, which is beneficial to improving the bending resistance of the display panel, for example, the size of the bending radius can be increased by more than 60%, which is beneficial to improving the crack problem of the display panel in the reliability test.

In the preparation process of the display panel of the present example, since a plurality of film layers of the color filter layer are all organic film layers, a plurality of development processes are needed during the preparation process, and if surfaces of the first contact pad and the second contact pad away from the base substrate are not protected, the surfaces of the first contact pad and the second contact pad away from the base substrate are susceptible to being corroded in the preparation process. Taking a case in which metal layers of the first contact pad and the second contact pad adopt the three-layer laminated structure of Ti/Al/Ti as an example, when the Al film layer is corroded during the preparation process, the Ti film layer will be extruded and stretched by the conductive ions during the bonding process, resulting in the formation of bonding bright lines by the connection of the Ti film layers of the adjacent contact pads, or the formation of dark lines, bonding position shift and other defects by the conductive ions due to the void caused by the corrosion of the Al film layer which is not pressed and broken. In this example, a first inorganic insulating thin film made of an inorganic material is used to protect the first contact pad and the second contact pad in the preparation process, which can prevent the metal layers of the first contact pad and the second contact pad from being corroded in the preparation process of the touch structure layer and the color filter layer. After the color filter layer is prepared, the first inorganic insulating thin film is etched to expose surfaces of the first contact pad and the second contact pad away from the base substrate for subsequent bonding connection. Moreover, since the dry etching process cannot etch through the organic film layer, only the first inorganic insulating thin film is used to cover the first contact pad and the second contact pad in the preparation process, and the organic film layers in the first signal access region and the second signal access region away from the first contact pad and the second contact pad are removed, which may be beneficial to etching the first inorganic insulating thin film covering the first contact pad and the second contact pad, and is conducive to simplifying the process and improving the yield of the display panel. In addition, traces of the signal access region of the present example may be arranged in a same layer as one or more display region metal layers of the circuit structure layer, and traces in a same layer as the first touch conductive layer and the second touch conductive layer may not be provided in the signal access region. By reducing trace film layers of the signal access region, short-circuiting caused by foreign matter or metal residue (Remain) in a gap between adjacent traces in the signal access region can be avoided.

After preparation of the above film layer structures is finished, the display panel may be stripped from the glass carrier plate through a stripping process.

The preparation process of this example may be implemented by using the existing mature preparation equipment, which has slight improvement on the existing processes, and may be well compatible with the existing preparation processes. The processes are easy to realize and easy to implement, with high production efficiency, low production costs, and high yield.

The structure and the manufacturing process of the display panel of this example are merely illustrative. In some examples, a corresponding structure may be changed and a patterning process may be added or reduced according to actual needs. For example, a passivation layer of the first source-drain metal layer away from the base substrate may be omitted, and an edge of the second contact pad metal layer of the first contact pad located at the first source-drain metal layer may be covered by the first planarization layer. As another example, the first inorganic insulating layer of the first bezel region and the first encapsulation layer or the third encapsulation layer of the encapsulation structure layer of the display region which are made of an inorganic material may be of a same layer structure. However, the embodiment is not limited thereto.

FIG. 11A is another schematic partial cross-sectional view of a first signal access region according to at least one embodiment of the present disclosure. FIG. 11A may be another schematic partial cross-sectional diagram along the direction P-P' in FIG. 4. FIG. 11B is another schematic partial cross-sectional view of a second signal access region according to at least one embodiment of the present disclosure. FIG. 11B may be another schematic partial cross-sectional diagram along a direction R-R' in FIG. 6. In some examples, as shown in FIG. 11A, the first contact pad 71 may include four contact pad metal layers which are stacked, including, for example, a first contact pad metal layer 711, a second contact pad metal layer 712, a third contact pad metal layer 713, and a fourth contact pad metal layer 714. The fourth contact pad metal layer 714 may be located in the third source-drain metal layer. An edge of the fourth contact pad metal layer 714 is not covered by the first inorganic insulating layer 701. The first inorganic insulating layer 701 may be located in a gap between adjacent first contact pads 71, and orthogonal projections of the first inorganic insulating layer 701 and the fourth contact pad metal layer 714 of the first contact pad 71 on the base substrate 10 may not be overlapped. The third planarization layer 107 may be in contact with an edge of the fourth contact pad metal layer 714, or an edge of the fourth contact pad metal layer 714 may be covered by the third planarization layer 107. In the present example, an organic film layer (e.g. the third planarization layer 107) may be used to protect the contact pad metal layer (in this example, the fourth contact pad metal layer 714) of the first contact pad farthest away from the base substrate.

In some examples, as shown in FIG. 11B, the second contact pad 72 may include two stacked contact pad metal layers, such as the fifth contact pad metal layer 721 and the sixth contact pad metal layer 722. The sixth contact pad metal layer 722 may be located in the third source-drain metal layer. An edge of the sixth contact pad metal layer 722 is not covered by the first inorganic insulating layer 701. The first inorganic insulating layer 701 may be located in a gap between adjacent second contact pads 72, and orthographic projections of the first inorganic insulating layer 701 and the sixth contact pad metal layer 722 of the second contact pad 72 on the base substrate 10 may not be overlapped. The third planarization layer 107 may cover an edge of the sixth contact pad metal layer 722. In this example, an organic film layer (e.g. the third planarization layer 107) may be used to cover the edge of the contact pad metal layer (in this example, the sixth contact pad metal layer 722) of the second contact pad farthest away from the base substrate to protect the second contact pad. In other examples, orthographic projections of surfaces of the first inorganic insulating layer 701 and the sixth contact pad metal layer 722 exposed by the third planarization layer 107 on the base substrate 10 may not be overlapped, and orthographic projections of the first inorganic insulating layer 701 and the sixth contact pad metal layer 722 covered by the third planarization layer 107 on the base substrate 10 may be partially overlapped.

The rest of the structure of the display panel in the example may refer to the description of the aforementioned embodiments, which will not be repeated here.

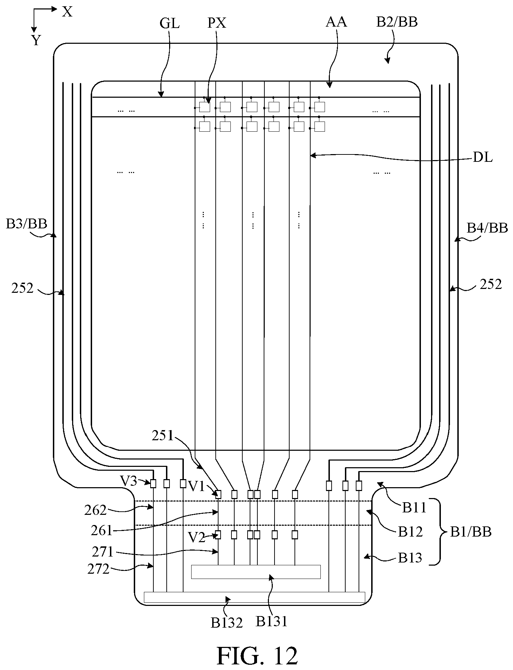

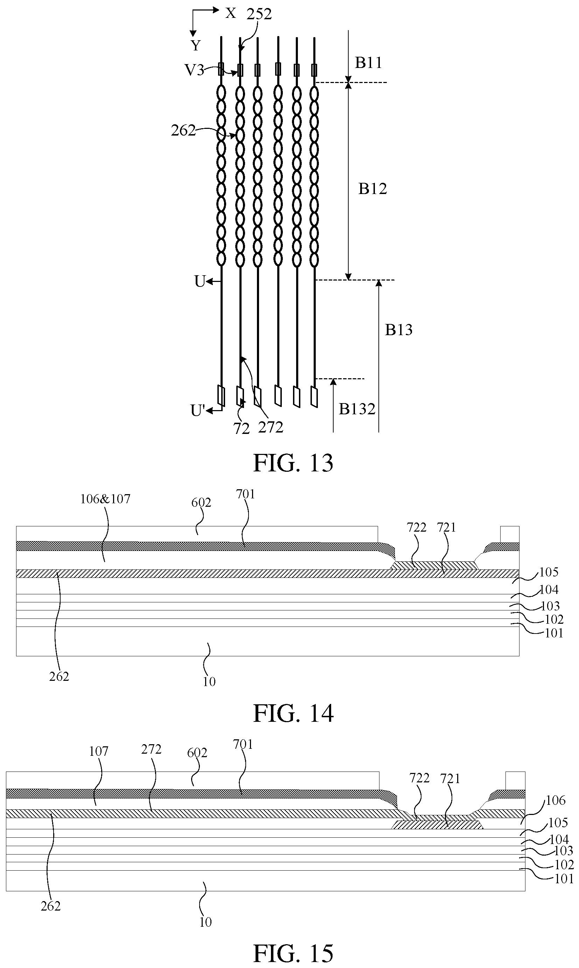

FIG. 12 is another schematic diagram of a display panel according to at least one embodiment of the present disclosure. FIG. 12 is a schematic plan view of the display panel before a bending process. FIG. 13 is a schematic partial plan view of traces of a first bezel region in FIG. 12. FIG. 14 is a schematic partial cross-sectional view along a direction U-U' in FIG. 13.

In some examples, as shown in FIG. 12, the display panel may include a display region AA and a peripheral region BB surrounding a periphery of the display region AA. The first bezel region B1 may include a fan-out trace region B11, a bending region B12, and a signal access region B13 arranged sequentially in a direction away from the display region AA. The plurality of display region metal layers of the display structure layer of the display region AA of the present example may include a first gate metal layer, a second gate metal layer, a first source-drain metal layer, a second source-drain metal layer, and a third source-drain metal layer.

In some examples, as shown in FIGS. 12-14, the touch leading out lines 252 within the fan-out trace region B11 of the first bezel region may be located in the first touch conductive layer or the second touch conductive layer, and the touch leading out line 252 may be electrically connected to the touch bending connection line 262 located in the second source-drain metal layer through the third transfer via V3 at a position of the fan-out trace region B11 close to the bending region B12. The touch bending connection line 262 may extend into the signal access region B13 and is electrically connected to the touch transfer line 272. In this example, the touch bending connection line 262 and the touch transfer line 272 may be of an integral structure and are located in the second source-drain metal layer. The touch transfer line 272 may extend to the second signal access region B132 and be electrically connected to the second contact pad 72 of the second signal access region B132. For example, the touch transfer line 272 and the fifth contact pad metal layer 721 of the second contact pad 72 may be of an integral structure. The sixth contact pad metal layer 722 of the second contact pad 72 may be located in the third source-drain metal layer and in contact with the fifth contact pad metal layer 721 through a contact via opened in the second planarization layer 106.

The touch bending connection line 262 and the touch transfer line 272 of this example are electrically in the signal access region without the need for the fourth transfer via, and the provision of the fourth transfer via can be omitted, which can save the opening process and simplify the preparation process.

With regard to the structure of the display region of the present example, the film layer structures of the first contact pad and the second contact pad may refer to descriptions of the aforementioned embodiments, and will not be repeated here.

FIG. 15 is another schematic partial cross-sectional view along a direction U-U' in FIG. 13. In some examples, as shown in FIGS. 12, 13, and 15, the plurality of display region metal layers of the display structure layer of the display region AA may include a first gate metal layer, a second gate metal layer, a first source-drain metal layer, a second source-drain metal layer, and a third source-drain metal layer. The plurality of bending connection lines of the bending region B12 of the present example may all be located in the third source-drain metal layer. However, the embodiment is not limited thereto. In other examples, the plurality of bending connection lines of the bending region may all be located in the first source-drain metal layer.

In some examples, as shown in FIGS. 13 and 15, the touch leading out lines 252 within the fan-out trace region B11 of the first bezel region may be located in the first touch conductive layer or the second touch conductive layer, and the touch leading out line 252 may be electrically connected to the touch bending connection line 262 located in the third source-drain metal layer through the third transfer via V3 at a position of the fan-out trace region B11 close to the bending region B12. The touch bending connection line 262 may extend into the signal access region B13 and is electrically connected to the touch transfer line 272. In this example, the touch bending connection line 262 and the touch transfer line 272 may be of an integral structure and are located in the third source-drain metal layer. The touch transfer line 272 may extend to the second signal access region B132 and be electrically connected to the second contact pad 72 of the second signal access region B132. For example, the touch transfer line 272 and the sixth contact pad metal layer 722 of the second contact pad 72 may be of an integral structure. The sixth contact pad metal layer 722 of the second contact pad 72 may be located in the third source-drain metal layer and in contact with the fifth contact pad metal layer 721 through a contact via opened in the second planarization layer 106. The fifth contact pad metal layer 721 may be located in the second source-drain metal layer.

With regard to the structure of the display region of the present example, the film layer structures of the first contact pad and the second contact pad may refer to descriptions of the aforementioned embodiments, and will not be repeated here.

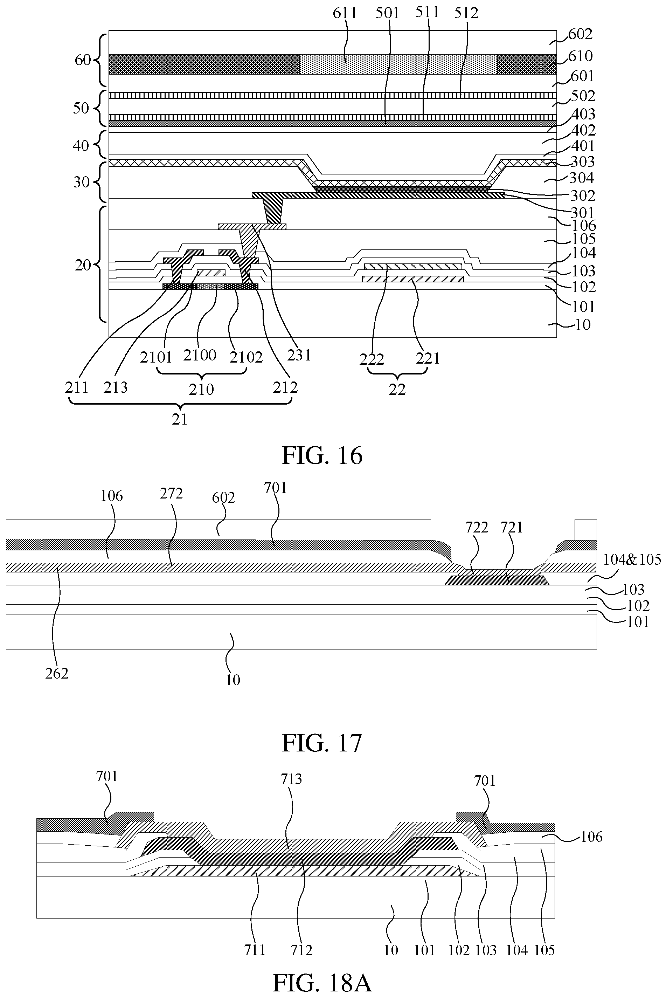

FIG. 16 is another schematic partial cross-sectional view of a display region of a display panel according to at least one embodiment of the present disclosure. FIG. 16 is illustrated by taking a structure of one sub-pixel of the display region as an example. In some examples, as shown in FIG. 16, in a direction perpendicular to the display panel, the display region of the display panel may include a base substrate 10, and a circuit structure layer 20, a light emitting structure layer 30, a encapsulation structure layer 40, a touch structure layer 50, and a color filter layer 60 that are sequentially disposed on the base substrate 10. The circuit structure layer 20 of the display region may include a semiconductor layer, a first gate metal layer, a second gate metal layer, a first source-drain metal layer, and a second source-drain metal layer disposed on the base substrate 10. A first gate insulating layer 101 may be disposed between the semiconductor layer and the first gate metal layer, a second gate insulating layer 102 may be disposed between the first gate metal layer and the second gate metal layer, an interlayer insulating layer 103 may be disposed between the second gate metal layer and the first source-drain metal layer, a passivation layer 104 and a first planarization layer 105 may be disposed between the first source-drain metal layer and the second source-drain metal layer, and a second planarization layer 106 may be disposed on a side of the second source-drain metal layer away from the base substrate 10. In this example, a drain 212 of a thin film transistor 21 of a pixel circuit may be electrically connected to a first electrode 301 of a light emitting element through a first transfer electrode 231 located in the second source-drain metal layer. A plurality of display region metal layers of the display structure layer of the present example may include a first gate metal layer, a second gate metal layer, a first source-drain metal layer, and a second source-drain metal layer. Rest of the film layers of description of the display panel of the example may refer to description of the aforementioned embodiments, and thus will not be repeated here.

In some examples, as shown in FIGS. 12 and 13, the touch leading out line 252 may be electrically connected to the touch bending connection line 262 located in the second source-drain metal layer through the third transfer via V3 at a position of the fan-out trace region B11 close to the bending region B12. The touch bending connection line 262 may extend into the signal access region B13 and is electrically connected to the touch transfer line 272. In this example, the touch bending connection line 262 and the touch transfer line 272 may be of an integral structure, for example, may be located in the second source-drain metal layer.

FIG. 17 is a schematic partial cross-sectional view of a signal access region according to at least one embodiment of the present disclosure. FIG. 17 may be another schematic partial cross-sectional diagram along a direction U-U' in FIG. 13. In some examples, as shown in FIG. 17, the touch bending connection line 262 and the touch transfer line 272 may be of an integral structure and may be located in the second source-drain metal layer. The touch transfer line 272 and the sixth contact pad metal layer 722 of the second contact pad 72 of the second signal access region may be of an integral structure. The fifth contact pad metal layer 721 of the second contact pad 72 may be located in the first source-drain metal layer. The sixth contact pad metal layer 722 of the second contact pad 72 may be electrically connected to the fifth contact pad metal layer 722 through contact vias opened in the passivation layer 104 and the first planarization layer 105. For example, an orthographic projection of the sixth contact pad metal layer 722 of the second contact pad 72 on the base substrate 10 may cover an orthographic projection of the fifth contact pad metal layer 721 on the base substrate 10.

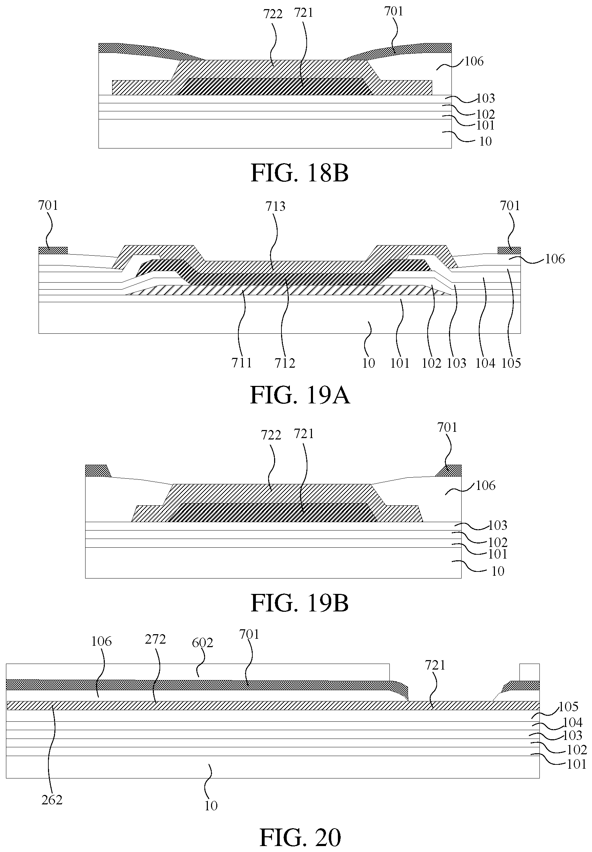

FIG. 18A is another schematic partial cross-sectional view of a first signal access region according to at least one embodiment of the present disclosure. FIG. 18A may be another schematic partial cross-sectional view of the first contact pad taken along a direction P-P' in FIG. 4. FIG. 18B is another schematic partial cross-sectional view of a second signal access region according to at least one embodiment of the present disclosure. FIG. 18B may be another schematic partial cross-sectional view of the second contact pad along a direction R-R' in FIG. 6.

In some examples, as shown in FIG. 18A, the first contact pad 71 of the first signal access region may include three contact pad metal layers which are stacked, including, for example, a first contact pad metal layer 711, a second contact pad metal layer 712, and a third contact pad metal layer 713. The third contact pad metal layer 713 may be located in the second source-drain metal layer, the second contact pad metal layer 712 may be located in the first source-drain metal layer, and the first contact pad metal layer 711 may be located in the first gate metal layer. The first inorganic insulating layer 701 may be located in a gap between adjacent first contact pads, and the first inorganic insulating layer 701 may cover an edge of the third contact pad metal layer 713. In other examples, the first contact pad metal layer 711 may be located in the second gate metal layer. The embodiment is not limited thereto.

In some examples, as shown in FIG. 18B, the second contact pad 72 of the second signal access region may include two contact pad metal layers that are stacked, including, for example, a fifth contact pad metal layer 721 and a sixth contact pad metal layer 722. The first inorganic insulating layer 701 may be located in a gap between adjacent second contact pads and the first inorganic insulating layer 701 may cover an edge of the sixth contact pad metal layer 722. For example, the first inorganic insulating layer 701 may cover an edge of the sixth contact pad metal layer 722 exposed by the second planarization layer 106. The sixth contact pad metal layer 722 of the present example may be located in the second source-drain metal layer and the fifth contact pad metal layer 721 may be located in the first source-drain metal layer.

The rest of the structure of the display panel in the example may refer to the description of the aforementioned embodiments, which will not be repeated here.

FIG. 19A is another schematic partial cross-sectional view of a first signal access region according to at least one embodiment of the present disclosure. FIG. 19A may be another schematic partial cross-sectional view of the first contact pad along a direction P-P' in FIG. 4. FIG. 19B is another schematic partial cross-sectional view of a second signal access region according to at least one embodiment of the present disclosure. FIG. 19B may be another schematic partial cross-sectional view of the second contact pad taken along a direction R-R' in FIG. 6.

In some examples, as shown in FIG. 19A, the first contact pad 71 of the first signal access region may include three contact pad metal layers which are stacked, including, for example, a first contact pad metal layer 711, a second contact pad metal layer 712, and a third contact pad metal layer 713. The first inorganic insulating layer 701 may be located in a gap between adjacent first contact pads 71 and orthographic projections of the first inorganic insulating layer 701 and the third contact pad metal layer 713 on the base substrate may be not overlapped. The third contact pad metal layer 713 may be located in the second source-drain metal layer, the second contact pad metal layer 712 may be located in the first source-drain metal layer, and the first contact pad metal layer 711 may be located in the first gate metal layer. In other examples, the first contact pad metal layer 711 may be located in the second gate metal layer. The embodiment is not limited thereto.

In some examples, as shown in FIG. 19B, the second contact pad 72 of the second signal access region may include two contact pad metal layers that are stacked, including, for example, a fifth contact pad metal layer 721 and a sixth contact pad metal layer 722. The first inorganic insulating layer 701 may be located in a gap between adjacent second contact pads 72 and orthographic projections of the first inorganic insulating layer 701 and the sixth contact pad metal layer 722 on the base substrate may be not overlapped. The sixth contact pad metal layer 722 may be located in the second source-drain metal layer and the fifth contact pad metal layer 721 may be located in the first source-drain metal layer. In other examples, orthographic projections of the first inorganic insulating layer 701 and a surface of the sixth contact pad metal layer 722 exposed by the second planarization layer 106 on the base substrate 10 may be not overlapped, and orthographic projections of the first inorganic insulating layer 701 and the sixth contact pad metal layer 722 covered by the second planarization layer 106 on the base substrate 10 may be partially overlapped.

The rest of the structure of the display panel in the example may refer to the description of the aforementioned embodiments, which will not be repeated here.

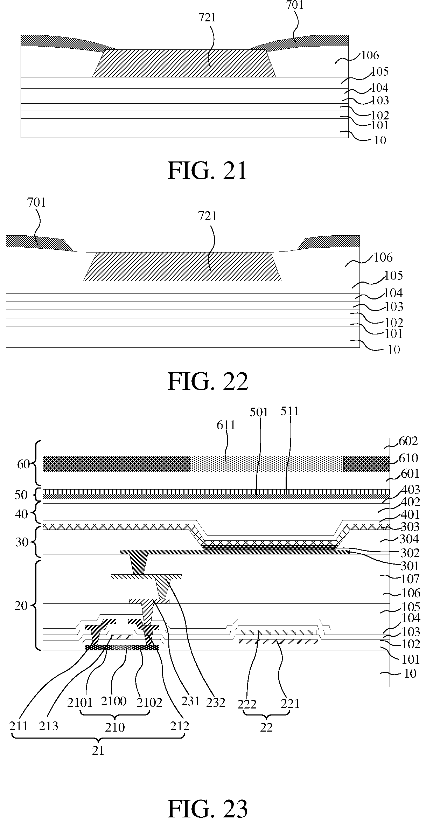

FIG. 20 is a schematic partial cross-sectional view of a signal access region according to at least one embodiment of the present disclosure. FIG. 20 may be another schematic partial cross-sectional diagram along a direction U-U'in FIG. 13. FIG. 21 is another schematic partial cross-sectional view of a second signal access region according to at least one embodiment of the present disclosure. FIG. 21 may be a schematic partial cross-sectional view of the second contact pad along a direction R-R' in FIG. 6. FIG. 22 is another schematic partial cross-sectional view of a second signal access region according to at least one embodiment of the present disclosure. FIG. 22 may be a schematic partial cross-sectional view of the second contact pad along a direction R-R' in FIG. 6. A plurality of display region metal layers of the display structure layer of the present example may include a first gate metal layer, a second gate metal layer, a first source-drain metal layer, and a second source-drain metal layer.

In some examples, as shown in FIGS. 20 and 21, the touch bending connection line 262 and the touch transfer line 272 may be of an integral structure and may be located in the second source-drain metal layer. The touch transfer line 272 and the fifth contact pad metal layer 721 of the second contact pad 72 of the second signal access region may be of an integral structure. The second contact pad 72 of the second signal access region may include a contact pad metal layer such as a fifth contact pad metal layer 721. As shown in FIG. 21, the first inorganic insulating layer 701 may be located in a gap between adjacent second contact pads 72 and may cover an edge of the fifth contact pad metal layer 721. As shown in FIG. 22, the first inorganic insulating layer 701 may be located in a gap between adjacent second contact pads 72 and orthographic projections of the first inorganic insulating layer 701 and the fifth contact pad metal layer 721 on the base substrate may be not overlapped.

The rest of the structure of the display panel and the structure of the first contact pad of the first signal access region in the example may refer to the description of the aforementioned embodiments, which will not be repeated here. The structure of the first contact pad of the first signal access region may be described with reference to FIG. 18A or FIG. 19A.

FIG. 23 is another schematic partial cross-sectional view of a display region of a display panel according to at least one embodiment of the present disclosure. FIG. 23 is illustrated by taking a structure of one sub-pixel of the display region as an example. In some examples, as shown in FIG. 23, in a direction perpendicular to the display panel, the display region of the display panel may include a base substrate 10, and a circuit structure layer 20, a light emitting structure layer 30, a encapsulation structure layer 40, a touch structure layer 50, and a color filter layer 60 that are sequentially disposed on the base substrate 10. The circuit structure layer 20 of the display region may include a semiconductor layer, a first gate metal layer, a second gate metal layer, a first source-drain metal layer, a second source-drain metal layer, and a third source-drain metal layer disposed on the base substrate 10. The touch structure layer 50 may include a touch buffer layer 501 and a first touch conductive layer 511 which are stacked. The display panel of this example is integrated with a self-capacitive touch structure, which can form an FSLOC structure. The structure of the first contact pad of the first signal access region and the structure of the second contact pad of the second signal access region of the display panel integrated with the FSLOC structure of the present example may be substantially the same as the structures of the first contact pad and the second contact pad of the display panel integrated with the FMLOC structure, which will not be repeated here.

The embodiment also provides a display panel including a base substrate, a display structure layer, a touch structure layer, a color filter layer, and a plurality of contact pads. The base substrate includes a display region and a first bezel region located on a side of the display region. The display structure layer is located on the base substrate of the display region, the touch structure layer is located on a side of the display structure layer away from the base substrate, and the color filter layer is located on a side of the touch structure layer away from the base substrate. A plurality of contact pads are located in the first bezel region. Orthographic projections of the touch structure layer and the color filter layer on the base substrate are not overlapped with orthographic projections of the plurality of contact pads on the base substrate.

In some exemplary implementation modes, the display panel further includes a first inorganic insulating layer located in the first bezel region, the first inorganic insulating layer is located on a side of the plurality of contact pads away from the base substrate, the first inorganic insulating layer exposes at least part of surfaces of the plurality of contact pads away from the base substrate. The touch structure layer includes a touch buffer layer, a first touch conductive layer, a touch interlayer insulating layer and a second touch conductive layer which are sequentially stacked away from a side of the base substrate. The first inorganic insulating layer and the touch buffer layer are of a same layer structure.

In some exemplary implementation modes, at least one contact pad of the plurality of contact pads includes: at least one contact pad metal layer. The first bezel region includes a first signal access region and a second signal access region, wherein the second signal access region is located at a side of the first signal access region away from the display region. The plurality of contact pads include a plurality of first contact pads located in the first signal access region and a plurality of second contact pads located in the second signal access region. A quantity of contact pad metal layers of at least one first contact pad of the plurality of first contact pads is greater than a quantity of contact pad metal layers of at least one second contact pad of the plurality of second contact pads.

Relevant description of the display panel of the present embodiment may refer to the descriptions in the aforementioned embodiments, and thus will not be repeated here.

An embodiment of the disclosure also provides a preparation method for a display panel, including: providing a base substrate, wherein the base substrate includes a display region and a first bezel region located on a side of the display region; forming a display structure layer in the display region and forming a plurality of contact pads in the first bezel region, wherein the display structure layer includes a plurality of display region metal layers, and at least one contact pad of the plurality of contact pads includes at least one contact pad metal layer; forming a touch structure layer on a side of the display structure layer away from the base substrate; and forming a first inorganic insulating layer in the first bezel region. The first inorganic insulating layer is located on a side of the plurality of contact pads away from the base substrate and exposes at least part of surfaces of contact pad metal layers of the plurality of contact pads away from the base substrate. The contact pad metal layer of the at least one contact pad exposed by the first inorganic insulating layer and one display region metal layer of the plurality of display region metal layers of the display structure layer are of a same layer structure.

In some exemplary implementation modes, forming the first inorganic insulating layer in the first bezel region includes: after the display structure layer is formed, depositing a first inorganic insulating thin film covering the plurality of contact pads in the first bezel region; and after the touch structure layer is formed, etching the first inorganic insulating thin film to form a first inorganic insulating layer.

In some exemplary implementation modes, the preparation method further includes: forming a color filter layer on a side of the touch structure layer away from the base substrate after forming the touch structure layer and before etching the first inorganic insulating thin film; wherein, the color filter layer includes a color film buffer layer, a black matrix, a plurality of filter units and a color film protection layer sequentially arranged at a side away from the base substrate, wherein both the color film buffer layer and the color film protection layer are organic insulating layers.

Regarding the preparation method of the display panel in this embodiment, reference may be made to descriptions of the aforementioned embodiments, and thus will not be repeated here.

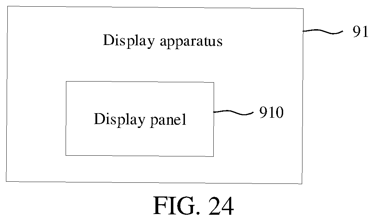

FIG. 24 is a schematic diagram of a display apparatus according to at least one embodiment of the present disclosure. As shown in FIG. 24, the present embodiment provides a display apparatus 91 including the display panel 910 of the aforementioned embodiments. In some examples, the display panel 910 may be an OLED display panel with an integrated touch structure. The display apparatus 91 may be any product or component with a display and touch function, such as a mobile phone, a tablet computer, a television, a display, a laptop, a digital photo frame, or a navigator.

The drawings of the present disclosure only involve structures involved in the present disclosure, and other structures may refer to conventional designs. The embodiments of the present disclosure, i.e., features in the embodiments, may be combined with each other to obtain new embodiments if there is no conflict. Those of ordinary skills in the art should understand that modifications or equivalent replacements may be made to the technical solutions of the present disclosure without departing from the essence and scope of the technical solutions of the present disclosure, and shall all fall within the scope of the claims of the present disclosure.

## Claims

1. A display panel, comprising:
a base substrate, comprising a display region and a first bezel region located on a side of the display region;
a display structure layer, located on the base substrate of the display region, wherein the display structure layer comprises a plurality of display region metal layers;
a touch structure layer, located on a side of the display structure layer away from the base substrate;
a plurality of contact pads, located in the first bezel region, wherein at least one contact pad of the plurality of contact pads comprises at least one contact pad metal layer; and
a first inorganic insulating layer, located in the first bezel region and on a side of the plurality of contact pads away from the base substrate, wherein the first inorganic insulating layer exposes at least part of surfaces of contact pad metal layers of the plurality of contact pads away from the base substrate;
wherein, the contact pad metal layer of the at least one contact pad exposed by the first inorganic insulating layer and one of the plurality of display region metal layers of the display structure layer are of a same layer structure.

2. The display panel according to claim 1, wherein the contact pad metal layer of the at least one contact pad exposed by the first inorganic insulating layer comprises a laminated structure of at least two metal materials.

3. The display panel according to claim 2, wherein the contact pad metal layer of the at least one contact pad exposed by the first inorganic insulating layer comprises a three-layer laminated structure of titanium aluminum titanium.

4. The display panel according to any one of claims 1 to 3, wherein the first inorganic insulating layer covers an edge of the contact pad metal layer of the at least one contact pad exposed by the first inorganic insulating layer.

5. The display panel according to claim 4, wherein an overlapping length of the first inorganic insulating layer with one side edge of the contact pad metal layer exposed is less than or equal to 10 microns.

6. The display panel according to any one of claims 1 to 3, wherein the first inorganic insulating layer is not overlapped with an edge of the contact pad metal layer of the at least one contact pad exposed by the first inorganic insulating layer.

7. The display panel according to any one of claims 1 to 6, wherein the display structure layer comprises a plurality of sub-pixels, at least one of the plurality of sub-pixels comprises a pixel circuit and a light emitting element, the pixel circuit is electrically connected to the light emitting element through a first transfer electrode and a second transfer electrode, the second transfer electrode is located at a side of the first transfer electrode away from the base substrate; the contact pad metal layer of the at least one contact pad exposed by the first inorganic insulating layer and the second transfer electrode are of a same layer structure.

8. The display panel according to claim 7, wherein the first bezel region comprises a signal access region, the signal access region comprises a first signal access region and a second signal access region, the second signal access region is located at a side of the first signal access region away from the display region; the plurality of contact pads comprise a plurality of first contact pads located in the first signal access region and a plurality of second contact pads located in the second signal access region;
a quantity of contact pad metal layers of at least one first contact pad of the plurality of first contact pads is greater than a quantity of contact pad metal layers of at least one second contact pad of the plurality of second contact pads.

9. The display panel according to claim 8, wherein the at least one first contact pad comprises a first contact pad metal layer, a second contact pad metal layer, a third contact pad metal layer, and a fourth contact pad metal layer that are sequentially stacked in a direction away from the base substrate.

10. The display panel according to claim 9, wherein the pixel circuit comprises at least one thin film transistor and at least one capacitor; the first contact pad metal layer of the at least one first contact pad and a first electrode plate or a second electrode plate of the at least one capacitor are of a same layer structure, the second contact pad metal layer and a source electrode and a drain electrode of the at least one thin film transistor are of a same layer structure, the third contact pad metal layer and the first transfer electrode are of a same layer structure, and the fourth contact pad metal layer and the second transfer electrode are of a same layer structure.

11. The display panel according to any one of claims 8 to 10, wherein the at least one second contact pad comprises a fifth contact pad metal layer and a sixth contact pad metal layer that are sequentially stacked in a direction away from the base substrate.

12. The display panel according to claim 11, wherein the fifth contact pad metal layer of the at least one second contact pad and the first transfer electrode are of a same layer structure, and the sixth contact pad metal layer and the second transfer electrode are of a same layer structure.

13. The display panel according to any one of claims 8 to 12, wherein the first bezel region further comprises a bending region and a fan-out trace region located at a side of the signal access region close to the display region, the fan-out trace region is located at a side of the bending region close to the display region;
the fan-out trace region is at least provided with a plurality of touch leading out lines;
the bending region is at least provided with a plurality of touch bending connection lines;
the signal access region is at least provided with a plurality of touch transfer lines;
a touch bending connection line of the plurality of touch bending connection lines is electrically connected with a touch leading out line of the plurality of touch leading out lines and a touch transfer line of the plurality of touch transfer lines, and the touch transfer line of the plurality of touch transfer lines and a contact pad metal layer of one of first contact pads connected with the touch transfer line are of an integral structure.

14. The display panel according to claim 13, wherein the touch bending connection line and the touch transfer line connected with the touch bending connection line are of an integral structure.

15. The display panel according to claim 13, wherein the touch bending connection line and the first transfer electrode are of a same layer structure, and the touch transfer line and the second transfer electrode are of a same layer structure.

16. The display panel according to any one of claims 1 to 6, wherein the display structure layer comprises a plurality of sub-pixels, at least one of the plurality of sub-pixels comprises a pixel circuit and a light emitting element; the pixel circuit is electrically connected with the light emitting element through a first transfer electrode; the contact pad metal layer of the at least one contact pad exposed by the first inorganic insulating layer and the first transfer electrode are of a same layer structure.

17. The display panel according to any one of claims 1 to 16, wherein the touch structure layer comprises a touch buffer layer, a first touch conductive layer, a touch interlayer insulating layer, and a second touch conductive layer sequentially stacked away from a side of the base substrate; the first inorganic insulating layer and the touch buffer layer are of a same layer structure; the touch interlayer insulating layer is an organic insulating layer.

18. The display panel according to any one of claims 1 to 17, further comprising: a color filter layer located on a side of the touch structure layer away from the base substrate, wherein the color filter layer comprises a color film buffer layer, a black matrix, a plurality of filter units, and a color film protection layer sequentially arranged away from a side of the base substrate; wherein, both the color film buffer layer and the color film protection layer are organic insulating layers.

19. A display apparatus, comprising the display panel according to any one of claims 1 to 18.

20. A preparation method for a display panel, comprising:
providing a base substrate, wherein the base substrate comprises a display region and a first bezel region located on a side of the display region;
forming a display structure layer in the display region and forming a plurality of contact pads in the first bezel region; wherein the display structure layer comprises a plurality of display region metal layers; at least one contact pad of the plurality of contact pads comprises at least one contact pad metal layer;
forming a touch structure layer on a side of the display structure layer away from the base substrate; and
forming a first inorganic insulating layer in the first bezel region; wherein the first inorganic insulating layer is located on a side of the plurality of contact pads away from the base substrate and exposes at least part of surfaces of contact pad metal layers of the plurality of contact pads away from the base substrate; the contact pad metal layer of the at least one contact pad exposed by the first inorganic insulating layer and one of the plurality of display region metal layers of the display structure layer are of a same layer structure.

21. The preparation method according to claim 20, wherein forming the first inorganic insulating layer in the first bezel region comprises:
after the display structure layer is formed, depositing a first inorganic insulating thin film covering the plurality of contact pads in the first bezel region; and
after the touch structure layer is formed, etching the first inorganic insulating thin film to form a first inorganic insulating layer.

22. The preparation method according to claim 21, further comprising: forming a color filter layer on a side of the touch structure layer away from the base substrate after forming the touch structure layer and before etching the first inorganic insulating thin film; wherein, the color filter layer comprises a color film buffer layer, a black matrix, a plurality of filter units and a color film protection layer sequentially arranged at a side away from the base substrate, wherein both the color film buffer layer and the color film protection layer are organic insulating layers.

23. A display panel, comprising:
a base substrate, comprising a display region and a first bezel region located on a side of the display region;
a display structure layer located on the base substrate of the display region;
a touch structure layer located on a side of the display structure layer away from the base substrate;
a color filter layer located on a side of the touch structure layer away from the base substrate; and
a plurality of contact pads located in the first bezel region;
wherein orthographic projections of the touch structure layer and the color filter layer on the base substrate are not overlapped with orthographic projections of the plurality of contact pads on the base substrate.

24. The display panel according to claim 23, further comprising: a first inorganic insulating layer located in the first bezel region, wherein the first inorganic insulating layer is located on a side of the plurality of contact pads away from the base substrate, the first inorganic insulating layer exposes at least part of surfaces of the plurality of contact pads away from the base substrate;
the touch structure layer comprises a touch buffer layer, a first touch conductive layer, a touch interlayer insulating layer and a second touch conductive layer which are sequentially stacked away from a side of the base substrate;
the first inorganic insulating layer and the touch buffer layer are of a same layer structure.

25. The display panel according to claim 23, wherein at least one contact pad of the plurality of contact pads comprises at least one contact pad metal layer;
the first bezel region comprises a first signal access region and a second signal access region, wherein the second signal access region is located at a side of the first signal access region away from the display region;
the plurality of contact pads comprise a plurality of first contact pads located in the first signal access region and a plurality of second contact pads located in the second signal access region;
a quantity of contact pad metal layers of at least one first contact pad of the plurality of first contact pads is greater than a quantity of contact pad metal layers of at least one second contact pad of the plurality of second contact pads.
